# EUROPEAN PATENT APPLICATION

(11) **EP 4 636 042 A1**
(43) Date of publication of application: **22.10.2025**
(21) Application number: 23903554.6
(22) Date of filing: 13.12.2023
(51) Int. Cl.: C08L 83/07, C08G 75/045, C08K 3/22, C08K 3/26, C08K 3/36, C08L 83/05, C08L 83/08

(54) **ULTRAVIOLET CURABLE SILICONE COMPOSITION**

(30) Priority: 14.12.2022 JP 2022199769
(71) Applicant: Momentive Performance Materials Japan LLC, Tokyo 107-6119 (JP)
(72) Inventor: OKAWA Koji, Tokyo 107-6119 (JP)
(74) Representative: Müller-Boré & Partner Patentanwälte PartG mbB
(86) International application number: PCT/JP2023/044740
(87) International publication number: WO 2024/128270

(57) **Abstract**

The present invention provides an ultraviolet-curable silicone composition which has excellent curing properties in the thickness direction and at parts that are not irradiated with light. Provided is an ultraviolet-curable silicone composition comprising (A) a polyorganosiloxane that has at least two alkenyl groups per molecule, (B) a polyorganosiloxane that has at least two mercaptoalkyl groups or hydrogen atoms bonded to a silicon atom per molecule, (C) an ultraviolet diffuser, and (D) a photoreaction initiator or platinum-based catalyst that is activated by ultraviolet rays. The amount of component (C) relative to 100 parts by mass of component (A) is 0.05-15.0 parts by mass. The transmission percentage of the composition prior to curing as measured with a wavelength of 365 nm and in accordance with JIS K 0115 is 33-95%.

## Description

### TECHNICAL FIELD

The present invention relates to an UV-curable silicone composition, and in particular, to an UV-curable silicone composition whose cured product can be suitably used as an encapsulating material for electrical components, electronic components, and the like.

### BACKGROUND ART

Silicone compositions are used as elastic adhesives, encapsulating materials, coating materials, electrical insulating and sealing materials, and the like for semiconductor elements such as ICs and LSIs, electric and electronic components in which these semiconductor elements, capacitors, resistors, and the like are mounted; optical components such as lenses, mirrors, filters, and prisms; and the like, as they have excellent heat resistance and provide good adhesion and bonding to these components. In particular, UV-curable addition-reaction type silicone compositions that utilize hydrosilylation are widely used as they are cured by ultraviolet irradiation in a short time, and thus have excellent productivity, and allow good adhesion between components.

As such an UV-curable silicone composition, Patent Literature 1 discloses an UV-curable organopolysiloxane gel composition for damping materials for objective lens drive devices, containing in a predetermined ratio: (A) an organopolysiloxane having on average 0.1 or more alkenyl groups bonded to silicon atoms per molecule; (B) an organohydrogenpolysiloxane having two or more hydrogen atoms bonded to silicon atoms per molecule; and (C) a photoactive platinum complex curing catalyst, and that it is possible to obtain a composition that combines the advantages of a predetermined polymer design with rapid curing by ultraviolet irradiation.

In addition, Patent Literature 2 discloses an UV-curable liquid silicone composition for image display devices, containing in a predetermined ratio: (A) an organopolysiloxane having a viscosity of 50 to 100,000 mPa·s at 25°C and containing at least two alkenyl groups per molecule; (B) an organohydrogenpolysiloxane such as a linear organohydrogenpolysiloxane having hydrogen atoms directly bonded to silicon atoms (Si-H groups) only at both ends of the molecular chain; and (C) one or more photoactive hydrosilylation reaction catalysts selected from a specific group of compounds, and having a predetermined viscosity, and discloses that the composition can be cured in a few minutes to a few tens of minutes under mild temperature conditions of 100°C or less, and provides a cured product with good mechanical and optical properties.

On the other hand, UV-curable silicone compositions using mercapto-functional polyorganosiloxanes, photoinitiators and various fillers are also known. For example, Patent Literature 3 discloses an UV-curable silicone composition containing: (A) a mercapto-functional polyorganosiloxane having the unit formula [(CH₃)₃SiO_{1/2}]ₓ[(CH₃)₂SiO]_{y}[R(CH₃)SiO]_{z} (wherein R is each independently a mercapto (C₁₋₃₀) hydrocarbyl group); at least one of a polyorganosiloxane and an organic molecule containing at least two aliphatic unsaturated carbon-carbon bonds; a filler such as silica powder or ceramic glass powder; and a photoinitiator.

Patent Literature 4 discloses an UV-curable silicone composition containing: (A) an alkenyl-functional, linear triorganosiloxy-terminated polydiorganosiloxane having at least two vinyl groups or the like bonded to silicon atoms per molecule; (B) a mercapto-functional cross-linking agent having at least two mercapto groups per molecule, represented by the general formula: R"R'₂SiO(R‴R'SiO)ₓ(R'RSiO)_{y}SiR'₂R" (each R is selected from mercaptoalkyl groups having 2 to 6 carbon atoms/groups, and each R" is selected from R and R' groups); (C) a photosensitizer; (D) a storage stabilizer, and optionally a reinforcing agent such as fumed silica.

Since the curing of such an UV-curable silicone composition is initiated by ultraviolet irradiation, there are problems such as the composition flowing before it is completely cured and areas not exposed to ultraviolet light being insufficiently cured. To solve such problems, various methods for curing UV-curable silicone compositions have been proposed. For example, Patent Literature 5 discloses a curing method including a step of heating after irradiating a composition with light having a specific emission spectrum, for the purpose of curing it while maintaining its shape in the initial stage of heating. In addition, Patent Literature 6 discloses a method for curing a composition, consisting of a first step of irradiating the composition with ultraviolet light to increase the catalytic activity of a photoactive platinum complex curing catalyst, and a second step of applying the composition obtained in the first step to a desired site and curing it, for the purpose of uniformly curing even areas not exposed to light or thick molded products.

On the other hand, silicone compositions such as thermosetting and moisture-curing types are also known to be formulated with light diffusing agents, inorganic ultraviolet absorbers, and the like. For example, Patent Literature 7 discloses a silicone rubber composition containing in a predetermined ratio: (A) a thermosetting silicone rubber mixture and (B) a diffusing agent consisting of inorganic particles including calcium carbonate having a predetermined particle size and refractive index, and that it can be used for manufacturing materials such as covers for lighting fixtures that require light diffusion properties. Patent Literatures 8 and 9 disclose light-diffusing dimethyl silicone rubber compositions in which a light diffusing agent consisting of silicone elastic particles or micro glass beads having a predetermined average particle size is dispersed in an uncrosslinked dimethyl silicone rubber compound at a predetermined ratio, and that they can be used for components intended for scattering LED light, and the like.

### CITATION LIST

### Patent Literature

Patent Literature 1: JP 2003-213132 A
Patent Literature 2: JP 2019-210351 A
Patent Literature 3: JP 2017-502102 A
Patent Literature 4: JP S60-110752 A
Patent Literature 5: JP 2012-121960 A
Patent Literature 6: JP 2013-87199 A
Patent Literature 7: JP 2013-185123 A
Patent Literature 8: JP 2011-184625 A
Patent Literature 9: JP 2012-33462 A

### SUMMARY OF INVENTION

### Technical Problem

While the UV-curable silicone compositions disclosed in Patent Literatures 1 to 4 are cured by irradiation of ultraviolet light and exhibit predetermined mechanical and optical properties, there were problems such as the curability being insufficient in areas not exposed to light and in the thickness direction, and the quality of the cured products being unstable. In addition, since the curing methods disclosed in Patent Literatures 5 and 6 require additional equipment and are complicated to operate, there is a need for an UV-curable silicone composition that provides a cured product with stable quality without using these methods. Furthermore, the compositions of Patent Literatures 7 to 9 were intended to be cured by heat and the resulting molded products were intended to be used in light diffusing components such as covers for lighting fixtures and the like. They were not intended to be cured by ultraviolet irradiation, and did not cure by ultraviolet light.

An object of the present invention is to provide an UV-curable silicone composition with excellent curability in areas not exposed to light and in the thickness direction.

### Solution to Problem

As a result of extensive research to solve the above problems, the present inventors have found that blending a predetermined amount of ultraviolet diffusing material into an UV-curable silicone composition and adjusting the transmittance of the composition to a predetermined range allows to improve the curability of the composition, and thereby completed the present invention.

The present invention relates to the following [1] to [17].
[1] An UV-curable silicone composition, comprising: (A) a polyorganosiloxane having at least two alkenyl groups per molecule; (B) a polyorganosiloxane having at least two hydrogen atoms or mercaptoalkyl groups bonded to silicon atoms per molecule; (C) an ultraviolet diffusing material; and (D) a platinum catalyst activated by ultraviolet light or a photoinitiator, wherein a content of the component (C) based on 100 parts by mass of the component (A) is 0.05 to 15.0 parts by mass, and a percent transmittance of the composition before curing, measured at a wavelength of 365 nm in accordance with JIS K 0115, is 33 to 95%.
[2] The UV-curable silicone composition according to [1], wherein an absorbance at a wavelength of 365 nm, of a mixture of 100 parts by mass of the component (A) and 0.25 parts by mass of the component (C), measured in accordance with JIS K 0115, using, instead of a glass cell, a sample produced by using a spacer and two glass plates to make the thickness of the mixture 200 µm, is in the range of 0.005 to 0.5.
[3] The UV-curable silicone composition according to [1] or [2], wherein a cured product, which is obtained by irradiating the composition with ultraviolet light having a diameter of 7.0 mm, an illuminance of 100 mW/cm², and a wavelength of 365 nm for 45 seconds in a yellow room, and then storing it at 23°C for 16 hours, has a curing diameter at a depth of 5.8 mm, of 18 mm or more.
[4] The UV-curable silicone composition according to any one of [1] to [3], wherein an average particle size of the component (C) is 0.01 to 25 µm.
[5] The UV-curable silicone composition according to any one of [1] to [4], wherein the component (C) is selected from the group consisting of calcium carbonate, silica, and alumina.
[6] The UV-curable silicone composition according to any one of [1] to [5], wherein the component (A) comprises a linear polyorganosiloxane, and an alkenyl group content of the component (A) is on average 0.03 to 1.0 mmol/g.
[7] The UV-curable silicone composition according to any one of [1] to [6], wherein the component (B) is (B-1) a polyorganohydrogensiloxane having at least two hydrogen atoms bonded to silicon atoms per molecule, and the component (D) is (D-1) a platinum catalyst activated by ultraviolet light.
[8] The UV-curable silicone composition according to [7], wherein the component (B-1) comprises (b1) a polyorganohydrogensiloxane comprising a R^{c1}₂HSiO_{1/2} unit (wherein R^{c1} is independently a C₁-C₆ alkyl group or a C₆-C₂₀ aryl group) and a SiO_{4/2} unit.
[9] The UV-curable silicone composition according to [7] or [8], wherein the component (D-1) is a platinum catalyst having a cyclic diene compound as a ligand, and a content of the component (D-1) in the composition is 1 to 50 ppm as platinum metal mass.
[10] The UV-curable silicone composition according to any one of [7] to [9], wherein a ratio of the number of moles H_{B} of hydrogen atoms bonded to silicon atoms in the component (B-1) to the number of moles Vi_{A} of alkenyl groups in the component (A), H_{B}/Vi_{A} ratio, is 0.3 to 2.0.
[11] The UV-curable silicone composition according to any one of [1] to [6], wherein the component (B) is (B-2) a polyorganosiloxane having at least two mercaptoalkyl groups bonded to silicon atoms per molecule, and the component (D) is (D-2) a photoinitiator.
[12] The UV-curable silicone composition according to [11], wherein the component (B-2) comprises (b2) a polyorganosiloxane comprising at least two R^{d1}SiO_{3/2} units (wherein R^{d1} is a mercaptoalkyl group having 1 to 6 carbon atoms) per molecule.
[13] A potting material, comprising the UV-curable silicone composition according to any one of [1] to [12].
[14] The potting material according to [13], which is for a connector pin.
[15] An encapsulating material, comprising a cured product of the UV-curable silicone composition according to any one of [1] to [12].
[16] The encapsulating material according to [15], which is for an electrical component or an electronic component.
[17] The encapsulating material according to [16], wherein the electrical component or electronic component is a connector having a connector pin.

### Advantageous Effects of Invention

The present invention can provide an UV-curable silicone composition with excellent curability in areas not exposed to light and in the thickness direction.

### BRIEF DESCRIPTION OF DRAWINGS

[Fig. 1] Fig. 1 is a photograph of a sample taken in a yellow room to measure the absorbance at a wavelength of 365 nm of a mixture of 100 parts by mass of the component (A) and 0.25 parts by mass of the component (C) and of an UV-curable silicone composition, in accordance with JIS K 0115.
[Fig. 2] Fig. 2 is a photograph taken from above of a device for measuring the curing diameter, in a yellow room.
[Fig. 3] Fig. 3 is a schematic diagram of the device of Fig. 2 when viewed from above.
[Fig. 4] Fig. 4 is a cross-sectional view of Fig. 3 at the A-A' line.
[Fig. 5] Fig. 5 is a schematic diagram describing the cured area and curing diameter after ultraviolet irradiation in Figs. 3 and 4.
[Fig. 6] Fig. 6 is a graph showing the relationship between the parts by mass of untreated calcium carbonate (average particle size: 2.0 µm), which is the component (C), based on 100 parts by mass of the component (A), and the curing diameters at the top (depth: 0 mm), middle (depth: 2.9 mm) and bottom (depth: 5.8 mm), based on Examples 1 to 6 and Comparative Examples 1 and 2.
[Fig. 7] Fig. 7 is a graph showing the relationship between the average particle size of calcium carbonate and the curing diameters at the top (depth: 0 mm), middle (depth: 2.9 mm) and bottom (depth: 5.8 mm), in a composition formulated with 0.25 parts by mass of calcium carbonate based on 100 parts by mass of the component (A), based on Examples 2 and 22 to 30.

### DESCRIPTION OF EMBODIMENTS

The UV-curable silicone composition comprises: (A) a polyorganosiloxane having at least two alkenyl groups per molecule; (B) a polyorganosiloxane having at least two hydrogen atoms or mercaptoalkyl groups bonded to silicon atoms per molecule; (C) an ultraviolet diffusing material; and (D) a platinum catalyst activated by ultraviolet light or a photoinitiator, wherein a content of the component (C) based on 100 parts by mass of the component (A) is 0.05 to 15.0 parts by mass, and a percent transmittance of the composition before curing, measured at a wavelength of 365 nm in accordance with JIS K 0115, is 33 to 95%. By blending the component (C) in a predetermined amount and having a percent transmittance of the composition before curing of 33 to 95%, it is possible to obtain an UV-curable silicone composition with excellent curability in areas not exposed to light and in the thickness direction.

From the viewpoint of curability of the composition, it is preferably a combination in which the component (B) is (B-1) a polyorganohydrogensiloxane having at least two hydrogen atoms bonded to silicon atoms per molecule, and the component (D) is (D-1) a platinum catalyst activated by ultraviolet light; or a combination in which the component (B) is (B-2) a polyorganosiloxane having at least two mercaptoalkyl groups bonded to silicon atoms per molecule, and the component (D) is (D-2) a photoinitiator.

The term "organic group," as used herein, means a group containing carbon. The valence of the organic group is indicated by referring to it as "n-valent," where n is any natural number. Therefore, for example, the term "monovalent organic group" means a group containing a carbon having only one bonding site. The bonding site may belong to an element other than carbon. Even when the valence is not specified, a person skilled in the art can recognize the appropriate valence from the context.

The term "hydrocarbon group," as used herein, means a group that contains carbon and hydrogen and that is obtained by removing at least one hydrogen atom from a molecule. The hydrocarbon group is not limited, and examples of a hydrocarbon group optionally substituted with one or more substituents include a hydrocarbon group having 1 to 20 carbon atoms, such as an aliphatic hydrocarbon group and an aromatic hydrocarbon group. The above "aliphatic hydrocarbon group" may be either linear, branched, or cyclic, and may be either saturated or unsaturated. In addition, the hydrocarbon group may contain one or more ring structures. The hydrocarbon group may have one or more heteroatoms or structures containing heteroatoms, such as a nitrogen atom (N), an oxygen atom (O), a sulfur atom (S), a silicon atom (Si), an amide bond, a sulfonyl bond, a siloxane bond, a carbonyl group, and a carbonyloxy group, at its end or in its molecular chain.

Each substituent of the "hydrocarbon group," as used herein, is not limited, but examples thereof include a halogen atom; and a group selected from a C₁₋₆ alkyl group, a C₂₋₆ alkenyl group, a C₂₋₆ alkynyl group, a C₃₋₁₀ cycloalkyl group, a C₃₋₁₀ unsaturated cycloalkyl group, a 5- to 10-membered heterocyclyl group, a 5- to 10-membered unsaturated heterocyclyl group, a C₆₋₁₀ aryl group, and a 5- to 10-membered heteroaryl group, each of which is optionally substituted with one or more halogen atoms.

In the present specification, an alkyl group and a phenyl group may be unsubstituted or substituted, unless otherwise specified. The substituents of these groups are not limited, but example thereof include one or more groups selected from a halogen atom, a C₁₋₆ alkyl group, a C₂₋₆ alkenyl group, and a C₂₋₆ alkynyl group.

When describing the structure of a siloxane compound herein, the structural units of the siloxane compound may be described by the following abbreviations. Hereinafter, these structural units may be referred to as an "M unit," "D unit," and the like.
M: (CH₃)₃SiO_{1/2}
M^{H}: H(CH₃)₂SiO_{1/2}
M^{Vi}: CH₂=CH(CH₃)₂SiO_{1/2}
D: (CH₃)₂SiO_{2/2}
D^{H}: H(CH₃)SiO_{2/2}
D^{Vi}: CH₂=CH(CH₃)SiO_{2/2}
T: CH₃SiO_{3/2}
T^{SH}: HS(CH₂)₃SiO_{3/2}
Q: SiO_{4/2} (tetrafunctional)

The siloxane compound is constructed by combining the above structural units, but may at least partially contain structural units in which the methyl groups are replaced with other groups, such as halogens such as fluorine or hydrocarbon groups such as phenyl groups. In addition, for example, when indicating D^{H}₂₀D₂₀, it does not mean that 20 D^{H} units are followed by 20 D units, and it should be understood that each of the units may be arranged arbitrarily. The siloxane compound can take a variety of three-dimensional structures depending on the T or Q unit.

### <Physical properties of UV-curable silicone composition>

### [Percent transmittance of composition before curing]

In the UV-curable silicone composition, a percent transmittance of the composition before curing, measured at a wavelength of 365 nm in accordance with JIS K 0115, is 33 to 95%. By having a percent transmittance in the above range, it is possible to obtain an UV-curable silicone composition with excellent curability in areas not exposed to light and in the thickness direction. When the percent transmittance is less than 33%, the curability of the composition is significantly reduced. When the percent transmittance exceeds 95%, the composition is cured by ultraviolet light, but the effect of improving curability in areas not exposed to light and in the thickness direction is small. The percent transmittance is preferably 33 to 90%, more preferably 33 to 88%, even more preferably 34 to 88%, still more preferably 40 to 85%, furthermore preferably 48 to 77%, yet more preferably 48 to 72%, and particularly preferably 50 to 67%.

The percent transmittance can be adjusted to the above range by appropriately selecting the type and content of (C) the ultraviolet diffusing material.

In the present invention, the percent transmittance of the composition before curing is measured as follows in accordance with JIS K 0115. Using 10 mm thick cells, the composition before curing is placed in a sample cell and ion-exchanged water in a control cell to measure the transmittance of the composition at a wavelength of 365 nm. The obtained measurements are then converted from a 10 mm thickness to a 1 mm thickness according to Lambert-Beer's law to obtain the percent transmittance of the composition.

### [Absorbance of mixture of 100 parts by mass of component (A) and 0.25 parts by mass of component (C)]

From the viewpoint of improving the curability in areas not exposed to light and in the thickness direction, an absorbance at a wavelength of 365 nm, of a mixture of 100 parts by mass of the component (A) and 0.25 parts by mass of the component (C), measured in accordance with JIS K 0115, using, instead of a glass cell, a sample produced by using a spacer and two glass plates to make the thickness of the mixture 200 µm, is in the range of preferably 0.005 to 0.5, more preferably 0.02 to 0.5, even more preferably 0.02 to 0.4, still more preferably 0.03 to 0.3, and particularly preferably 0.05 to 0.2.

### [Absorbance of composition before curing]

From the viewpoint of improving the curability in areas not exposed to light and in the thickness direction, an absorbance at a wavelength of 365 nm, of the UV-curable silicone composition before curing, measured in accordance with JIS K 0115, using, instead of a glass cell, a sample produced by using a spacer and two glass plates to make the thickness of the composition 200 µm, is in the range of preferably 0.005 to 3.0, more preferably 0.015 to 2.7, more preferably 0.02 to 2.6, and particularly preferably 0.02 to 1.0.

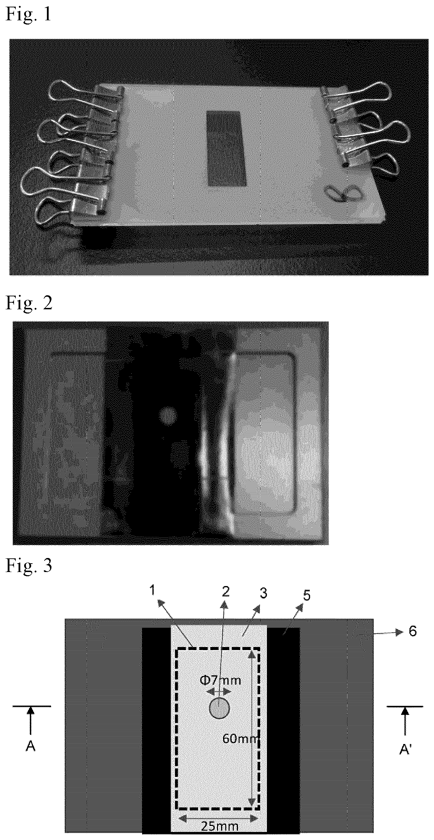

In Fig. 1 is shown a photograph of a sample taken to measure the absorbance at a wavelength of 365 nm of the mixture and the composition in accordance with JIS K 0115. As shown in Fig. 1, a sample is produced by using a spacer and two glass plates to make the thickness of the mixture or the composition 200 µm, and this is used as a sample cell instead of a glass cell. The glass plate used is a microscopic glass slide S9112 (76 mm x 52 mm x 1.0 to 1.2 mm thick, manufactured by Matsunami Glass Ind., Ltd). In Fig. 1, the white area is the area where the two glass plates are superposed, and the mixture or the composition with a thickness of 200 µm is present in the transparent cut-out area in the glass plate. One microscopic glass slide S9112 as described above is used for the control cell.

### <(A) Polyorganosiloxane having at least two alkenyl groups per molecule>

The component (A) is a polyorganosiloxane having at least two alkenyl groups per molecule. The component (A) functions as a base polymer for the UV-curable silicone composition. The alkenyl group may be bonded to the molecular chain end of the molecular main chain, to a side chain in the middle of the molecular chain, or to both. In the present specification, the molecular main chain refers to the relatively longest bonded chain in the molecule. The molecular structure of the component (A) is not limited as long as the siloxane bond is the main backbone, and may be linear, branched, cyclic, or in a three-dimensional network, and the siloxane backbone may be interrupted by a divalent organic group. The component (A) may be used alone, or in combination of two or more.

The component (A) has at least two alkenyl groups per molecule. The component (A) can be a mixture of a plurality of polyorganosiloxanes having at least two alkenyl groups per molecule. In particular, from the viewpoint of forming a stable three-dimensional structure by a cross-linking reaction during curing and providing adequate hardness to the cured product, the component (A) preferably contains a linear polyorganosiloxane, and more preferably a linear polyorganosiloxane having one alkenyl group on each end of the molecular main chain. In this case, the component (A) preferably contains 30 mass% or more, more preferably 50 mass% or more, and even more preferably 80 mass% or more of linear polyorganosiloxane based on 100 mass% of the component (A). The upper limit of the content of linear polyorganosiloxane is 100 mass% based on 100 mass% of the component (A).

The alkenyl group is not limited as long as it is a group that has a carbon-carbon double bond and can undergo an addition reaction. The number of carbon atoms of the alkenyl group is preferably 2 to 20, more preferably 2 to 8, and even more preferably 2 to 6. The alkenyl group may have a branched structure or a ring structure. The position of the carbon-carbon double bond in the hydrocarbon constituting the alkenyl group can be any position. In terms of reactivity, the carbon-carbon double bond is preferably at the end of the group. Preferred examples of the alkenyl group include a vinyl group, as it allows easy synthesis of the polyorganosiloxane.

The alkenyl group content of the component (A) is not limited, but can be 0.02 mmol/g or more on average. The alkenyl group content of the component (A) is, on average, preferably 0.02 to 2.0 mmol/g, more preferably 0.03 to 1.0 mmol/g, even more preferably 0.03 to 0.5 mmol/g, still more preferably 0.04 to 0.5 mmol/g, and particularly preferably 0.10 to 0.50 mmol/g. By having an alkenyl group content in the above range, it is possible to obtain an UV-curable silicone composition with excellent curability in areas not exposed to light and in the thickness direction, as well as storage stability. When the component (A) is a mixture of a plurality of polyorganosiloxanes, the alkenyl group content of the component (A) is the average value of the mixture.

The alkenyl group content of the component (A) can be determined from the absorbance of the CH₂=CH- group (around 2,150 nm) using a spectrophotometer.

In one aspect of the present invention, the component (A) has at least two alkenyl groups bonded to silicon atoms per molecule. The component (A) forms a network structure by an addition reaction with a hydrosilyl group (Si-H group) of the component (B-1) or a mercapto group of the component (B-2) described below. The component (A) typically has at least two alkenyl group-containing siloxane units represented by a general formula (1):

R¹ₘR²ₙSiO_{(4-m-n)/2} (1)

wherein
R¹ is an unsubstituted or substituted monovalent hydrocarbon group having no aliphatic unsaturated bonds;
R² is an alkenyl group;
m is an integer of 0 to 2; and
n is an integer of 1 to 3, provided that m + n is 1 to 3,
per molecule.

R¹ is an unsubstituted or substituted monovalent hydrocarbon group having no aliphatic unsaturated bonds. Specific examples of R¹ include an alkyl group, such as a C₁-C₆ alkyl group (e.g., methyl, ethyl, and propyl); a cycloalkyl group, such as a C₃-C₁₀ cycloalkyl group (e.g., cyclohexyl); an aryl group, such as a C₆-C₂₀ aryl group (e.g., phenyl, tolyl, xylyl, naphthyl, and anthracenyl); an aralkyl group, such as a C₇-C₁₃ aralkyl group (e.g., 2-phenylethyl and 2-phenylpropyl); and a substituted hydrocarbon group, such as a halogen-substituted hydrocarbon group (e.g., chloromethyl, chlorophenyl, and 3,3,3-trifluoropropyl). In terms of ease of synthesis and the like, alkyl groups are preferred, of which methyl, ethyl, and propyl are preferred, and methyl is more preferred. An aryl group can be used in combination to adjust the refractive index, of which phenyl is preferred in terms of ease of synthesis and the like.

From the viewpoint of obtaining an UV-curable silicone composition with excellent curability and storage stability, the component (A) preferably contains a linear polyorganosiloxane having one alkenyl group on each end of the molecular main chain. In one aspect of the present invention, the linear polyorganosiloxane can be represented by, for example, a formula (I): 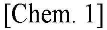 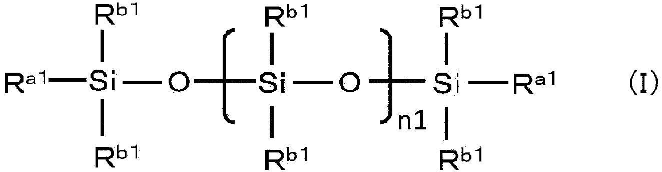 wherein
R^{a1} is independently a C₂-C₆ alkenyl group;
R^{b1} is independently a C₁-C₆ alkyl group or a C₆-C₂₀ aryl group; and
n1 is a number at which the alkenyl group content of the linear polyorganosiloxane is on average 0.02 mmol/g or more.

Examples of the C₂-C₆ alkenyl group include a vinyl group, an allyl group, a 3-butenyl group, and a 5-hexenyl group. Examples of the C₁-C₆ alkyl group include a methyl group, an ethyl group, a propyl group, a butyl group, a pentyl group, and a hexyl group. Examples of the C₆-C₂₀ aryl group include a phenyl group, a naphthyl group, and an anthracenyl group.

R^{a1} is preferably a vinyl group as it is easy to synthesize and does not impair the fluidity of the composition before curing and the heat resistance of the cured product. R^{b1} is preferably a C₁-C₆ alkyl group, and particularly preferably a methyl group, as it is easy to synthesize and has an excellent balance between the fluidity of the composition, the mechanical strength of the cured product, and the like. Therefore, the component (A) is preferably a polymethyl vinyl siloxane in which both ends are blocked with dimethyl vinyl siloxane units and the intermediate units consist of dimethyl siloxane units.

The content of the polymethyl vinyl siloxane in which both ends are blocked with dimethyl vinyl siloxane units and the intermediate units consist of dimethyl siloxane units, in 100 mass% of the component (A), is preferably 30 mass% or more, more preferably 50 mass% or more, and even more preferably 80 mass% or more. The upper limit of the content is 100 mass%.

From the viewpoint of ensuring a stable liquid state of the composition and curability in areas not exposed to light and in the thickness direction, n1 is preferably a number at which the alkenyl group content of the linear polyorganosiloxane is on average 0.02 mmol/g or more, more preferably 0.02 to 2.0 mmol/g, even more preferably 0.03 to 1.0 mmol/g, still more preferably 0.03 to 0.5 mmol/g, furthermore preferably 0.04 to 0.5 mmol/g, and particularly preferably 0.10 to 0.50 mmol/g.

The viscosity of the component (A) at 23°C is preferably 10 to 100,000 mPa·s, more preferably 100 to 50,000 mPa·s, and even more preferably 100 to 10,000 mPa·s.

In the present specification, the viscosity of each component and the UV-curable silicone composition is a value measured using a rotational viscometer with a No. 1, 2, 3 or 4 rotor, at 0.3 to 60 rpm and 23°C, in accordance with JIS K 6249.

The component (A) may be a mixture of a polymethyl vinyl siloxane in which both ends are blocked with dimethyl vinyl siloxane units and the intermediate units consist of dimethyl siloxane units, and another linear, branched or cyclic alkenyl group-containing polyorganosiloxane.

A commercial product can be used as the component (A). In addition, a polyorganosiloxane in which an alkenyl group has been introduced by a known reaction may also be used. As the component (A), only one type of compound may be used, or a mixture of two or more types of compounds may be used, classified based on the position or type of substituent, degree of polymerization, and the like. Since the component (A) is a polyorganosiloxane, it may be a mixture of polyorganosiloxanes having various degrees of polymerization.

From the viewpoint of balance between handleability, curability, and storage stability, the content of the component (A) is preferably 70.0 to 99.8 mass%, more preferably 80.0 to 99.7 mass%, and even more preferably 90.0 to 99.7 mass%, based on 100 mass% of the UV-curable silicone composition.

### <(B) Polyorganosiloxane having at least two hydrogen atoms or mercaptoalkyl groups bonded to silicon atoms per molecule>

The component (B) is a polyorganosiloxane having at least two hydrogen atoms or mercaptoalkyl groups bonded to silicon atoms per molecule. The component (B) functions as a crosslinking agent, and forms a network structure by an addition reaction with an alkenyl group of the component (A). The component (B) may be used alone, or in combination of two or more. Hereinafter, (B-1) a polyorganohydrogensiloxane having at least two hydrogen atoms bonded to silicon atoms per molecule, and (B-2) a polyorganosiloxane having at least two mercaptoalkyl groups bonded to silicon atoms per molecule will be specifically described.

### <(B-1) Polyorganohydrogensiloxane having at least two hydrogen atoms bonded to silicon atoms per molecule>

The hydrogen atoms of the component (B-1) may be bonded to a silicon atom of the molecular chain end, to a silicon atom in the middle of the molecular chain, or to both. The molecular structure of the component (B-1) is not limited as long as the siloxane bond is the main backbone, and may be linear, branched, cyclic, or in a three-dimensional network, and the siloxane backbone may be interrupted by a divalent organic group. In addition, the component (B-1) may also have a hydroxy group or an alkoxy group such as a methoxy group or an ethoxy group bonded to a silicon atom. The component (B-1) may be used alone, or in combination of two or more.

The component (B-1) typically has at least two siloxane units containing hydrogen atoms bonded to silicon atoms, represented by a general formula (2):

R³ₚH_{q}SIO_{(4-p-q)/2} (2)

wherein
R³ is an unsubstituted or substituted monovalent hydrocarbon group having no aliphatic unsaturated bonds;
p is an integer of 0 to 2; and
q is an integer of 1 to 3, provided that p + q is 1 to 3, per molecule. Examples of R³ include the same as those of R¹ in the general formula (1), and the preferred aspects are also the same. In the component (B-1), the number of hydrogen atoms bonded to silicon atoms is preferably 3 to 100, and more preferably 5 to 50 per molecule.

The component (B-1) preferably contains (b1) a polyorganohydrogensiloxane containing a R^{c1}₂HSiO_{1/2} unit (wherein R^{c1} is independently a C₁-C₆ alkyl group or a C₆-C₂₀ aryl group) and a SiO_{4/2} unit. The present inventors have found that when the composition is irradiated with ultraviolet light, the component (b1) has a high ability to cure the composition not only in the irradiated area but also in a three-dimensional extension of that area. When the component (B-1) contains the component (b1), it is possible to obtain a composition with even better curability in the unexposed areas surrounding the irradiated area and in the thickness direction.

The component (b1) may be either branched, cyclic, or forming a three-dimensional network structure (a dense structure of SiO_{4/2} units). R^{c1} is preferably a C₁-C₆ alkyl group, and particularly preferably methyl in terms of ease of synthesis and the like.

In particular, the component (b1) is preferably a polyorganohydrogensiloxane in which 3 to 6 SiO_{4/2} units and 6 to 12 R^{c1}₂HSiO_{1/2} units are bonded; and particularly preferably a cyclic polyorganohydrogensiloxane in which 3 to 6 SiO_{4/2} units form a cyclic siloxane backbone and each SiO_{4/2} unit is bonded to two R^{c1}₂HSiO_{1/2} units, such as [R^{c1}₂HSiO_{1/2}]₆[SiO_{4/2}]₃, [R^{c1}₂HSiO_{1/2}]₈[SiO_{4/2}]₄, [R^{c1}₂HSiO_{1/2}]₁₀[SiO_{4/2}]₅, and [R^{c1}₂HSiO_{1/2}]₁₂[SiO_{4/2}]₆.

The viscosity of the component (B-1) at 23°C is preferably 1 to 100 mPa·s, and more preferably 1 to 50 mPa·s.

A commercial product can be used as the component (B-1). In addition, the component (B-1) can also be synthesized by a known reaction. As the component (B-1), only one type of compound may be used, or a mixture of two or more types of compounds may be used, classified based on the position or type of substituent, degree of polymerization, and the like. Since the component (B-1) is a polyorganohydrogensiloxane, it may be a mixture of polyorganohydrogensiloxanes having various degrees of polymerization.

From the viewpoint of handleability, curability, and extensibility of the curing range, a ratio of the number of moles H_{B} of hydrogen atoms bonded to silicon atoms in the component (B-1) to the number of moles Vi_{A} of alkenyl groups in the component (A), H_{B}/Vi_{A} ratio, is preferably 0.3 to 2.0, even more preferably 0.4 to 1.5, and particularly preferably 0.5 to 1.1.

### [(B-2) Polyorganosiloxane having at least two mercaptoalkyl groups bonded to silicon atoms per molecule]

The mercaptoalkyl groups of the component (B-2) may be bonded to a silicon atom of the molecular chain end, to a silicon atom in the middle of the molecular chain, or to both. The molecular structure of the component (B-2) is not limited as long as the siloxane bond is the main backbone, and may be linear, branched, cyclic, or in a three-dimensional network, and the siloxane backbone may be interrupted by a divalent organic group. In addition, the component (B-2) may also have a hydroxy group or an alkoxy group such as a methoxy group or an ethoxy group bonded to a silicon atom. The component (B-2) may be used alone, or in combination of two or more.

The component (B-2) typically has at least two siloxane units containing mercaptoalkyl groups bonded to silicon atoms, represented by a general formula (3): 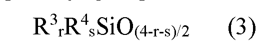 wherein
R³ is an unsubstituted or substituted monovalent hydrocarbon group having no aliphatic unsaturated bonds;
R⁴ is a mercaptoalkyl group having 1 to 6 carbon atoms;
r is an integer of 0 to 2; and
s is an integer of 1 to 3, provided that r + s is 1 to 3,
per molecule. From the point of view of ensuring a stable structure by a cross-linking reaction and suppressing excessive cure shrinkage, the number of mercaptoalkyl groups bonded to silicon atoms is preferably 2 to 20, more preferably 3 to 10, and even more preferably 3 to 7 per molecule.

Examples of R⁴ include mercaptomethyl, 2-mercaptoethyl, 3-mercaptopropyl, 4-mercaptobutyl, and 6-mercaptohexyl, but in terms of ease of synthesis and the like, mercaptomethyl and 3-mercaptopropyl are preferred, and 3-mercaptopropyl is more preferred. Examples of R³ include the same as those of R¹ in the general formula (1), and the preferred aspects are also the same.

From the viewpoint of crosslinkability, the component (B-2) preferably contains (b2) a polyorganosiloxane containing at least two R^{d1}SiO_{3/2} units (wherein R^{d1} is a mercaptoalkyl group having 1 to 6 carbon atoms) per molecule. In particular, the component (b2) more preferably contains at least two R^{d1}SiO_{3/2} units as well as a R³₃SiO_{1/2} unit and a R³₂SiO_{2/2} unit per molecule.

In terms of work efficiency and crosslinkability, the ratio of the number of R^{d1}SiO_{3/2} units to the number of siloxane units free of mercaptoalkyl groups is preferably 1:60 to 1:5, but is not limited thereto.

From the viewpoint of ensuring curability and mechanical properties of the cured product, the content of the component (b2) based on 100 mass% of the component (B-2) is preferably 50 mass% or more, more preferably 70 mass% or more, and even more preferably 90 mass% or more. The upper limit of the content of the component (b2) based on 100 mass% of the component (B-2) is 100 mass%.

The viscosity of the component (B-2) at 23°C is preferably 20 to 25,000 mPa·s, more preferably 50 to 10,000 mPa·s, and even more preferably 100 to 1,000 mPa·s.

The method for preparing the component (B-2) is not limited, and it can be produced, for example, by hydrolyzing, polycondensing, or re-equilibrating a mercaptoalkylalkoxysilane, such as mercaptopropyltrimethoxysilane, mercaptopropyltriethoxysilane, mercaptopropylmethyldimethoxysilane, mercaptopropylmethyldiethoxysilane, mercaptopropyldimethylmethoxysilane, or mercaptopropyldimethylethoxysilane, with a desired alkylchlorosilane, alkylalkoxysilane, or silanol-containing siloxane.

A commercial product can be used as the component (B-2). In addition, the component (B-2) can also be synthesized by a known reaction. As the component (B-2), only one type of compound may be used, or a mixture of two or more types of compounds may be used, classified based on the position or type of substituent, degree of polymerization, and the like. Since the component (B-2) is a polyorganosiloxane, it may be a mixture of polyorganosiloxanes having various degrees of polymerization.

The number of mercapto groups in the component (B-2) can be measured by colorimetric titration with iodine. This is a method utilizing the reaction of the following formula:

2RSH + I₂→RSSR + 2HI

which utilizes the fact that a small amount of excess iodine turns the titrant slightly yellow during titration.

From the viewpoint of handleability, curability, and extensibility of the curing range, a ratio of the number of moles SH_{B} of mercaptoalkyl groups bonded to silicon atoms in the component (B-2) to the number of moles Vi_{A} of alkenyl groups in the component (A), SH_{B}/Vi_{A} ratio, is preferably 0.3 to 2.0, even more preferably 0.4 to 1.5, and particularly preferably 0.5 to 1.1.

### <(C) Ultraviolet diffusing material>

The component (C) is a component which greatly improves the curability in areas not exposed to light and in the thickness direction, when the composition is irradiated with ultraviolet light. The component (C) may be used alone, or in combination of two or more.

In the UV-curable silicone composition, the percent transmittance of the composition before curing, measured at a wavelength of 365 nm in accordance with JIS K 0115, is 33 to 95%. The component (C) is not limited as long as it brings the percent transmittance of the composition before curing into the above range. The component (C) may be surface treated with a hydrophobizing agent such as a fatty acid.

Examples of the component (C) include calcium carbonate, silica, alumina, magnesium oxide, calcium oxide, glass beads, and glass balloons. Of these, from the viewpoint of improving curability in areas not exposed to light and in the thickness direction, the component (C) is preferably selected from the group consisting of calcium carbonate, silica, and alumina and is even more preferably calcium carbonate.

From the viewpoint of improving curability in areas not exposed to light and in the thickness direction, the average particle size of the component (C) is preferably 0.01 to 25 µm, more preferably 0.01 to 15 µm, even more preferably 0.01 to 10 µm, still more preferably 0.01 to 3.0 µm, and particularly preferably 0.01 to 2.0 µm. In addition, from the viewpoint of handleability, the lower limit of the average particle size of the component (C) is preferably 0.1 µm or more. The average particle size is the median diameter d50 of the primary particle size as measured by a laser diffraction/scattering method. When the component (C) is agglomerated, 50 agglomerated primary particles are observed using an optical microscope, and the average of the largest diameters is used as the average particle size.

From the viewpoint of improving the curability in areas not exposed to light and in the thickness direction, the content of the component (C) based on 100 parts by mass of the component (A) is 0.05 to 15.0 parts by mass, preferably 0.10 to 10.0 parts by mass, more preferably 0.10 to 5.0 parts by mass, even more preferably 0.10 to 2.0 parts by mass, still more preferably 0.10 to 1.0 part by mass, and particularly preferably 0.10 to 0.25 parts by mass. When the content of the component (C) is less than 0.05 parts by mass, the effect of improving curability in areas not exposed to light will not be obtained, and when it exceeds 15.0 parts by mass, the curability in areas not exposed to light and in the thickness direction will be rather reduced.

### <(D) Platinum catalyst activated by ultraviolet light or photoinitiator>

The component (D) is a platinum catalyst activated by ultraviolet light or a photoinitiator. From the viewpoint of crosslinkability, when the component (B) is the component (B-1), the component (D) is preferably (D-1) a platinum catalyst activated by ultraviolet light. In addition, from the viewpoint of crosslinkability, when the component (B) is the component (B-2), the component (D) is preferably (D-2) a photoinitiator.

### <(D-1) Platinum catalyst activated by ultraviolet light>

The component (D-1) is a catalyst activated by ultraviolet light to promote addition reactions between an alkenyl group of the component (A) and a hydrosilyl group (Si-H group) of the component (B), particularly the component (B-1). From the viewpoint of good catalyst activity, the component (D-1) is preferably a platinum catalyst having a cyclic diene compound as a ligand. The component (D-1) may be used alone, or in combination of two or more.

Examples of platinum catalysts having a cyclic diene compound as a ligand include a (1,5-cyclooctadienyl)diphenyl platinum complex, a (1,5-cyclooctadienyl)dipropyl platinum complex, a (2,5-norbornadiene)dimethyl platinum complex, a (2,5-norbornadiene)diphenyl platinum complex, a (cyclopentadienyl)dimethyl platinum complex, a (methylcyclopentadienyl)diethyl platinum complex, a (trimethylsilylcyclopentadienyl)diphenyl platinum complex, a (methylcycloocta-1,5-dienyl)diethyl platinum complex, a (cyclopentadienyl)trimethyl platinum complex, a (cyclopentadienyl)ethyldimethyl platinum complex, a (cyclopentadienyl)acetyldimethyl platinum complex, a (methylcyclopentadienyl)trimethyl platinum complex, a (methylcyclopentadienyl)trihexyl platinum complex, a (trimethylsilylcyclopentadienyl)trimethyl platinum complex, a (dimethylphenylsilylcyclopentadienyl)triphenyl platinum complex, and a (cyclopentadienyl)dimethyltrimethylsilylmethyl platinum complex.

From the viewpoint of curability of the composition, the content of the component (D-1) in the UV-curable silicone composition is preferably an amount that results in 1 to 50 ppm, more preferably 4 to 50 ppm, and even more preferably 10 to 50 ppm as platinum metal mass.

Similarly, the content of the component (D-1) based on the total mass of the component (A) and the component (B) is preferably an amount that results in 1 to 50 ppm, more preferably 4 to 50 ppm, and even more preferably 10 to 50 ppm as platinum metal mass.

### [(D-2) Photoinitiator]

The component (D-2) is a component that functions as a radical initiator or sensitizer when photocrosslinking an alkenyl group of the component (A) with a mercapto group of the component (B), particularly the component (B-2). From the viewpoint of reactivity, examples of the component (D-2) include aromatic hydrocarbons, acetophenone and derivatives thereof, benzophenone and derivatives thereof, o-benzoyl benzoate esters, benzoin, benzoin ethers and derivatives thereof, xanthone and derivatives thereof, disulfide compounds, quinone compounds, halogenated hydrocarbons and amines, and organic peroxides. From the viewpoint of compatibility between the components (A) and (B-2), and stability, a compound containing a substituted or unsubstituted benzoyl group or an organic peroxide is more preferred. The component (D-2) may be used alone, or in combination of two or more.

Examples of the component (D-2) include acetophenone, propiophenone, 2,2-dimethoxy-1,2-diphenylethan-1-one (IRGACURE (registered trademark) 651: manufactured by IGM Resins B.V.), 2-hydroxy-2-methyl-1-phenylpropanone (Irgacure (registered trademark) 1173: manufactured by IGM Resins B.V.), 1-hydroxycyclohexyl-phenyl-ketone (IRGACURE (registered trademark) 184: manufactured by IGM Resins B.V.), 1-[4-(2-hydroxyethoxy)-phenyl]-2-hydroxy-2-methyl-1-propan-1-one (IRGACURE (registered trademark) 2959: manufactured by IGM Resins B.V.), 2-hydroxy-1-{4-[4-(2-hydroxy-2-methyl-propionyl)-benzyl]phenyl}-2-methyl-propan-1-one (IRGACURE (registered trademark) 127: manufactured by IGM Resins B.V.), 2-methyl-1-(4-methylthiophenyl)-2-morpholinopropan-1-one (IRGACURE (registered trademark) 907: manufactured by IGM Resins B.V.), 2-benzyl-2-dimethylamino-(4-morpholinophenyl)-butanone-1 (IRGACURE (registered trademark) 369: manufactured by IGM Resins B.V.), 2-(dimethylamino)-2-[(4-methylphenyl)methyl]-1-[4-(4-morpholinyl)phenyl]-1-butanone (IRGACURE (registered trademark) 379: manufactured by IGM Resins B.V.); 2,4,6-trimethylbenzoyl-diphenyl-phosphine oxide (LUCIRIN TPO: manufactured by IGM Resins B.V.), bis(2,4,6-trimethylbenzoyl)-phenylphosphine oxide (IRGACURE (registered trademark) 819: manufactured by IGM Resins B.V.); 1,2-octanedione, 1-[4-(phenylthio)-, 2-(O-benzoyloxime)] (IRGACURE (registered trademark) OXE 01: manufactured by IGM Resins B.V.), ethanone, 1-[9-ethyl-6-(2-methylbenzoyl)-9H-carbazol-3-yl]-, 1-(O-acetyloxime) (IRGACURE (registered trademark) OXE 02: manufactured by IGM Resins B.V.); a mixture of 2-[2-oxo-2-phenylacetoxyethoxy]ethyl ester and 2-(2-hydroxyethoxy)ethyl ester (IRGACURE (registered trademark) 754: manufactured by IGM Resins B.V.), phenylglyoxylic acid methyl ester (DAROCUR (registered trademark) MBF: manufactured by IGM Resins B.V.), ethyl-4-dimethylaminobenzoate (DAROCUR (registered trademark) EDB: manufactured by IGM Resins B.V.), 2-ethylhexyl-4-dimethylaminobenzoate (DAROCUR (registered trademark) EHA: manufactured by IGM Resins B.V.), bis(2,6-dimethoxybenzoyl)-2,4,4-trimethyl-pentylphosphine oxide (CGI 403: manufactured by IGM Resins B.V.), benzoyl peroxide, and cumene peroxide.

From the viewpoint of curability of the composition, the content of the component (D-2) in the UV-curable silicone composition is preferably 0.05 to 10 mass%, more preferably 0.1 to 10 mass%, and even more preferably 0.1 to 5 mass%.

Similarly, the content of the component (D-2) based on the total mass of the component (A) and the component (B) is preferably 0.05 to 10 mass%, more preferably 0.1 to 10 mass%, and even more preferably 0.1 to 5 mass%.

### <Other Components>

The UV-curable silicone composition can be formulated with other components as long as they do not undermine its purpose and effect. As the other components, fire retardants, adhesion-imparting agents, heat resistance-imparting agents, diluents, inhibitors of addition reaction curing catalysts, resins other than polyorganosiloxane, and the like can be blended as appropriate. In addition, the UV-curable silicone composition can be formulated with a polyorganosiloxane other than the component (A), such as a polyorganosiloxane having one or less alkenyl groups per molecule; a polyorganohydrogensiloxane other than the component (B-1), such as a polyorganohydrogensiloxane having one hydrogen atom bonded to a silicon atom per molecule; a polyorganosiloxane other than the component (B-2), such as a polyorganosiloxane having one mercaptoalkyl group bonded to a silicon atom per molecule; an inorganic or organic pigment other than the component (C), and the like. The other components may be each used alone, or in combination of two or more.

### <Method for producing UV-curable silicone composition>

The UV-curable silicone composition can be obtained by mixing the components (A) to (D) and, if necessary, other components with a mixer such as a planetary mixer. During mixing, the components may be mixed while heating in the range of 50 to 150°C, as necessary. For a uniform finish, it is preferable to perform a kneading operation with high shear force. Examples of kneading devices include three-roll mills, colloid mills, and sand grinders, of which methods using three-roll mills are preferred.

The UV-curable silicone composition can also be a two-part composition, in consideration of the storage stability of the composition. In the case of a two-part composition, it is preferable that the first part contains the components (A), (C) and (D), but no component (B); and that the second part contains the components (A) and (B) and optionally the component (C), but no component (D). In a two-part UV-curable silicone composition, the first part and the second part are prepared separately. The first part and the second part can be produced by the same method as for a one-part composition.

From the viewpoint of handleability and curability in the unexposed areas surrounding the area irradiated with ultraviolet light and in the thickness direction, the viscosity of the UV-curable silicone composition at 23°C is preferably 10 to 100,000 mPa·s, more preferably 100 to 60,000 mPa·s, and even more preferably 100 to 20,000 mPa·s.

When the UV-curable silicone composition is a two-part composition consisting of a first part and a second part, the viscosities of the first part and second part are preferably 10 to 100,000 mPa·s, more preferably 100 to 60,000 mPa·s, and even more preferably 100 to 20,000 mPa·s. The UV-curable silicone composition is preferably stored under light shielding and at normal temperature or less.

### <Method for curing UV-curable silicone composition>

The UV-curable silicone composition can be cured by irradiation of ultraviolet light. The irradiation dose is preferably 100 to 10,000 mJ/cm², more preferably 300 to 6,000 mJ/cm², and even more preferably 500 to 5,000 mJ/cm². The irradiation dose is the measured value for UVA. Here, UVA refers to ultraviolet light with a wavelength in the range of 315 to 400 nm. The composition has good curability when irradiated with ultraviolet light having a wavelength, for example, in the range of 250 to 450 nm. Examples of light sources emitting ultraviolet light of such wavelengths include a highpressure mercury lamp (UV-7000) and a metal halide lamp (UVL-4001M3-N1) manufactured by Ushio Inc., a metal halide lamp (JM-MTL 2KW) manufactured by JM Tech Co., Ltd, Korea, an ultraviolet irradiation lamp (OSBL360) manufactured by Mitsubishi Electric Corporation, an ultraviolet irradiation machine (UD-20-2) manufactured by GS Yuasa Corporation, a fluorescent lamp (FL-20BLB) manufactured by Toshiba Corporation, an H bulb, H+ bulb, V bulb, D bulb, Q bulb and M bulb manufactured by Heraeus, and an LED lamp (HLDL-155UV) manufactured by CCS Inc.

The curing time of the composition depends on the dose of ultraviolet irradiation, but is generally 30 minutes or less, and preferably 10 minutes or less. Whether or not the curing of the composition has progressed can be determined visually, but it can also be evaluated quantitatively by the time taken for the storage elastic modulus G' and the loss elastic modulus G" to become equal, the time taken for the storage elastic modulus G' to reach a predetermined value, and the like. For example, when the time taken for the storage elastic modulus G' to become equal to the loss elastic modulus G" at 23°C after ultraviolet irradiation is within 30 minutes, preferably within 10 minutes, it is preferable because the time required for curing is short and handleability is excellent.

### <Curability of UV-curable silicone composition>

The UV-curable silicone composition has excellent curability in areas not exposed to light and in the thickness direction. Specifically, the cured product, which is obtained by irradiating the UV-curable silicone composition with ultraviolet light having a diameter of 7.0 mm, an illuminance of 100 mW/cm², and a wavelength of 365 nm for 45 seconds in a yellow room, and then storing it at 23°C for 16 hours, has a curing diameter at a depth of 5.8 mm, of preferably 18 mm or more, more preferably 20 mm or more, and even more preferably 23 mm or more.

In addition, the cured product, which is obtained by irradiating the UV-curable silicone composition with ultraviolet light having a diameter of 7.0 mm, an illuminance of 100 mW/cm², and a wavelength of 365 nm for 45 seconds in a yellow room, and then storing it at 23°C for 16 hours, has a curing diameter at a depth of 2.9 mm, of preferably 14 mm or more, more preferably 15 mm or more, and even more preferably 16 mm or more. Furthermore, the cured product, which is obtained by irradiating the UV-curable silicone composition with ultraviolet light having a diameter of 7.0 mm, an illuminance of 100 mW/cm², and a wavelength of 365 nm for 45 seconds in a yellow room, and then storing it at 23°C for 16 hours, has a curing diameter at a depth of 0 mm, of preferably 7 mm or more, more preferably 11 mm or more, and even more preferably 12 mm or more.

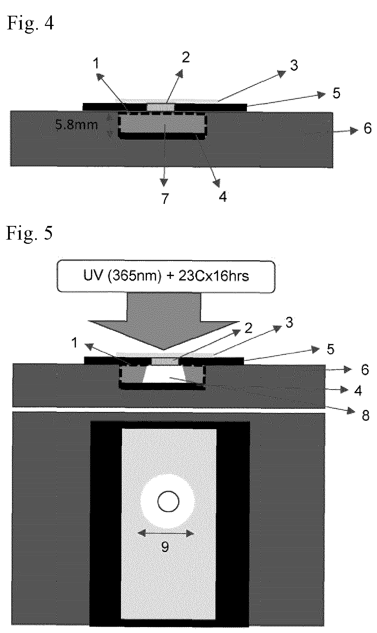

The method for measuring the curing diameter will be described using Figs. 2 to 5. Fig. 2 is a photograph taken from above of a device for measuring the curing diameter in a yellow room, and Fig. 3 is a schematic diagram of the device when viewed from above. Fig. 4 is a cross-sectional view of Fig. 3 at the A-A' line. Fig. 5 is a schematic diagram describing the cured area and curing diameter after ultraviolet irradiation in Figs. 3 and 4.

A yellow room refers to an environment in which light with wavelengths of 500 nm or less, including ultraviolet light, is shielded, and specifically, it means an environment in which wavelengths of 500 nm or less are cut off by 98% or more from light of a fluorescent lamp. A yellow room is generally provided, for example, when handling photosensitive materials in a clean room of a semiconductor plant. For example, a yellow room can be obtained by using a windowless room and a commercially available yellow fluorescent lamp as lighting. Examples of commercially available yellow fluorescent lamps include a yellow light straight tube LED lamp manufactured by Toshiba Corporation.

As shown in Figs. 3 and 4, a metal mold 6 with a rectangular depression 1 (within the dashed lines in Figs. 3 and 4) of 60 mm in length, 25 mm in width, and 6.0 mm in depth is prepared. To prevent reflection of ultraviolet light, a black tape for the bottom 4 (0.2 mm thick) is applied to the entire bottom surface of the depression 1. Then, in a yellow room, the depression 1 is filled with a sample 7 (compositions of the Examples and Comparative Examples), and a black tape for the top 5 (0.2 mm thick) with a hole 2 of 7.0 mm diameter is applied to cover the top of the composition. Furthermore, a 1 mm thick, transparent glass 3, which is one size larger than the size of the depression 1, is placed on top of the black tape for the top 5.

The sample 7 thus installed is irradiated with ultraviolet light having an illuminance of 100 mW/cm² and a wavelength of 365 nm for 45 seconds (irradiation dose of 4,500 mJ/cm²) through the hole 2 using a UV-LED irradiator manufactured by CCS Inc., and then stored at 23°C for 16 hours. The sample 7 is cured within the cured area 8, as shown in Fig. 5. The black tape for the top 5 is removed, the metal mold 6 is propped to remove the uncured portion, and the maximum diameters of the cured top (depth: 0 mm), middle (depth: 2.9 mm) and bottom (depth: 5.8 mm) are each measured with a caliper to obtain the cured diameter of the top, middle and bottom, respectively.

### <Use application of UV-curable silicone composition>

The UV-curable silicone composition has excellent work efficiency and crosslinking curability, and can therefore be suitably used in a potting material. Specifically, the UV-curable silicone composition can be suitably used in a material with an area less exposed to light, particularly a potting material for a connector pin.

In another aspect of the present invention, the cured product of the UV-curable silicone composition can be suitably used as an encapsulating material. Since an article using the cured product of the UV-curable silicone composition as an encapsulating material has excellent water resistance and durability performance on the adhesive surface and at the encapsulated part, the cured product can be suitably used as an encapsulating material for an electrical component or an electronic component. In addition, the UV-curable silicone composition has excellent curability in the unexposed areas surrounding the area irradiated with ultraviolet light and in the thickness direction, and the quality of the cured product is stable. Therefore, it can be used, for example, as an adhesive for bonding image display devices such as liquid crystal, plasma, and organic EL, or as an encapsulating material to encapsulate LED or OLED devices. In particular, the encapsulating material containing the cured product of the UV-curable silicone composition can be suitably used for an electrical or electronic component, and is particularly suitable for a connector having a connector pin.

### Examples

Next, the present invention will be described in more detail using Examples and Comparative Examples. However, the present invention is not limited by these Examples. Indications are in parts by mass or mass%, unless otherwise specified.

### <Measurement Methods>

### [Refractive Index]

The refractive indices of the components (A) and (A') were measured at 25°C in accordance with JIS K 0062.

### [Average Particle Size]

The components (C) and (C') were observed using an optical microscope (Digital Microscope, VHX-500F, manufactured by Keyence Corporation) to confirm the presence or absence of agglomeration. When no agglomeration was observed in the components (C) and (C'), as their average particle size (median diameter d50), the primary particle size was measured using a laser diffraction/scattering particle size analyzer (LS13 320, manufactured by Beckman Coulter, Inc.). When the components (C) and (C') were agglomerated, 50 agglomerated primary particles were observed using the optical microscope, and the average of the largest diameters was used as the average particle size.

### [Viscosity]

The viscosity at 23°C of the component (A) and the compositions of the Examples and Comparative Examples was measured using a rotational viscometer (Vismetron VDA2 type, manufactured by Shibaura System Co., Ltd.) with a No. 2 rotor at 60 rpm, in accordance with JIS K 6249. The viscosity was measured immediately after the preparation of the compositions and after storing outside of the yellow room at 23°C for 24 hours.

### [Percent Transmittance]

The percent transmittance of the compositions before curing in the Examples and Comparative Examples was measured in accordance with JIS K 0115. Using 10 mm thick cells, the composition before curing was placed in a sample cell and ion-exchanged water in a control cell to measure the transmittance of the composition at a wavelength of 365 nm. The obtained measurements were then converted from a 10 mm thickness to a 1 mm thickness according to Lambert-Beer's law to obtain the percent transmittance of the composition.

### [Absorbance]

### (1) Preparation of mixture of 100 parts by mass of component (A) and 0.25 parts by mass of component (C) or (C')

For the component (A) and the component (C) or (C') constituting the compositions of the Examples and Comparative Examples, a mixture of 100 parts by mass of the component (A) and 0.25 parts by mass of the component (C) or (C') was prepared. 25 parts by mass of the component (C) or (C') was added to 25 parts by mass of the component (A), and the mixture was stirred for 2 minutes with a rotating/revolving mixer (ARE-501, manufactured by Thinky Corporation). Then, 50 parts by mass of the component (A) was added in 10 parts by mass at a time to avoid clumping, and the mixture was stirred for 2 minutes at each addition using the rotating/revolving mixer to prepare a base solution. To the base solution thus obtained was added the component (A) little by little to avoid clumping, and the mixture was stirred for 2 minutes at each addition using the rotating/revolving mixer to obtain a mixture of 100 parts by mass of the component (A) and 0.25 parts by mass of the component (C) or (C').

### (2) Measurement of absorbance

The absorbance at a wavelength of 365 nm was measured for the mixture obtained as above and the compositions of the Examples and Comparative Examples in accordance with JIS K 0115.

In Fig. 1 is shown a photograph of a sample taken to measure the absorbance at a wavelength of 365 nm of the mixture and the composition in accordance with JIS K 0115. As shown in Fig. 1, a sample was produced by using a spacer and two glass plates to make the thickness of the mixture or the composition 200 µm, and this was used as a sample cell instead of a glass cell. The glass plate used was a microscopic glass slide S9112 (76 mm x 52 mm x 1.0 to 1.2 mm thick, manufactured by Matsunami Glass Ind., Ltd). In Fig. 1, the white area is the area where the two glass plates are superposed, and the mixture or composition with a thickness of 200 µm is present in the transparent cut-out area in the glass plate. One microscopic glass slide S9112 as described above was used for the control cell.

### [Shore 00 Hardness]

The compositions of the Examples and Comparative Examples were poured into a mold of 60 mm in length x 25 mm in width x 6 mm in depth, cured by irradiation with ultraviolet light with an illuminance of 100 mW/cm² for 45 seconds using an HLDL-155UV manufactured by CCS Inc., and then stored at 23°C and 50 RH% for 16 hours. The Shore 00 hardness of the cured product thus obtained was measured in accordance with ASTM D 2240. If the composition did not cure at all with ultraviolet irradiation, it was indicated as "uncured." If the ultraviolet-irradiated side was cured but the opposite side was not, it was indicated as "bottom uncured."

### [Penetration]

The penetration was measured for the composition of Example 14, which had a Shore 00 hardness of 0, using a penetrometer in accordance with JIS K 6249. The penetration for Example 14 was 25.

### [Gelling time]

The storage elastic modulus G' from the start of the ultraviolet irradiation was measured over time for the compositions of the Examples and Comparative Examples using a viscoelasticity measuring device MCR301 (manufactured by Anton Paar GmbH). Using the viscoelasticity measuring device, the measurement of the storage elastic modulus G' at 23°C of the UV-curable silicone composition was started using a parallel plate with a diameter of 12 mm, with a gap of 0.5 mm, a frequency of 1 Hz and a strain of 1%. The UV-curable silicone composition was irradiated with ultraviolet light with an illuminance of 100 mW/cm² for 45 seconds (irradiation dose of 4,500 mJ/cm²), and the time from the start of irradiation until the storage elastic modulus G' became equal to the loss elastic modulus G" was considered as the gelling time. It was considered that the shorter the gelling time, the faster the curing and the better the curability. The gelling time was measured up to 60 minutes after the start of ultraviolet irradiation, and if the storage elastic modulus G' was less than the loss elastic modulus G", it was considered "uncured."

### [Curing Diameter]

The curing diameter was measured as an indicator of the extent to which the composition can be cured when irradiated with ultraviolet light, which includes not only the irradiated area but also the extent of the extended area. Fig. 2 is a photograph taken from above of a device to perform the above measurements in a yellow room, and Fig. 3 is a schematic diagram of the device when viewed from above. Fig. 4 is a cross-sectional view of Fig. 3 at the A-A' line. Fig. 5 is a schematic diagram describing the cured area and curing diameter after ultraviolet irradiation in Figs. 3 and 4.

As shown in Figs. 3 and 4, a metal mold 6 with a rectangular depression 1 (within the dashed lines in Figs. 3 and 4) of 60 mm in length, 25 mm in width, and 6.0 mm in depth was prepared. To prevent reflection of ultraviolet light, a black tape for the bottom 4 (0.2 mm thick) was applied to the entire bottom surface of the depression 1. Then, in a yellow room, the depression 1 was filled with a sample 7 (compositions of the Examples and Comparative Examples), and a black tape for the top 5 (0.2 mm thick) with a hole 2 of 7.0 mm diameter was applied to cover the top of the composition. Furthermore, a 1 mm thick, transparent glass 3, which was one size larger than the size of the depression 1, was placed on top of the black tape for the top 5.

The sample 7 thus installed was irradiated with ultraviolet light having an illuminance of 100 mW/cm² and a wavelength of 365 nm for 45 seconds (irradiation dose of 4,500 mJ/cm²) through the hole 2 using a UV-LED irradiator manufactured by CCS Inc., and then stored at 23°C for 16 hours. The sample 7 is cured within the cured area 8, as shown in Fig. 5. The black tape for the top 5 was removed, the metal mold 6 was propped to remove the uncured portion, and the maximum diameters of the cured top (depth: 0 mm), middle (depth: 2.9 mm) and bottom (depth: 5.8 mm) were each measured with a caliper to obtain the cured diameter of the top, middle and bottom, respectively. If the curing diameter was 7.0 mm or more for the top, 14 mm or more for the middle, and 18 mm or more for the bottom, the curability in the unexposed areas surrounding the area irradiated with ultraviolet light and in the thickness direction was considered to be excellent. If the composition did not cure with ultraviolet irradiation, it was indicated as "uncured."

### <Components used>

The components used are as follows. Here, the symbols mean the following:
M: (CH₃)₃SiO_{1/2}
M^{H}: H(CH₃)₂SiO_{1/2}
M^{Vi}: CH₂=CH(CH₃)₂SiO_{1/2}
D: (CH₃)₂SiO_{2/2}
D^{H}: H(CH₃)SiO_{2/2}
D^{Vi}: CH₂=CH(CH₃)SiO_{2/2}
T^{SH}: HS(CH₂)₃SiO_{3/2}
Q: SiO_{4/2} (tetrafunctional)

### Component (A): polyorganosiloxane having at least two alkenyl groups per molecule

The polymethyl vinyl siloxanes shown below were used, in which both ends are blocked with M^{Vi} units and the intermediate units consist of D units.
(A-1) M^{Vi}Dₘ₁M^{Vi} (1): average vinyl group content of 0.180 mmol/g, viscosity at 23°C: 450 mPa·s, refractive index: 1.403
(A-2) M^{Vi}Dₘ₂M^{Vi} (2): average vinyl group content of 0.047 mmol/g, viscosity at 23°C: 12,800 mPa·s, refractive index: 1.403
(A-3) M^{Vi}Dₘ₃M^{Vi} (3): average vinyl group content of 0.029 mmol/g, viscosity at 23°C: 78,800 mPa·s, refractive index: 1.404
(A-4) M^{Vi}Dₘ₄M^{Vi} (4): average vinyl group content of 0.145 mmol/g (consisting of 5 mol% diphenylsiloxane and 95 mol% dimethylsiloxane), viscosity at 23°C: 1,300 mPa·s, refractive index: 1.428

The alkenyl group content of the component (A) was determined from the absorbance of the CH₂=CH- group (around 2,150 nm) using a spectrophotometer.
Component (A'): Siloxane oligomer with methacrylic functional groups at both ends
   (A'-1) 1,3-Bis(3-methacryloxypropyl)tetramethyldisiloxane (TSL9706, manufactured by Momentive Performance Materials Japan LLC, refractive index: 1.450)
Component (B): polyorganosiloxane having at least two hydrogen atoms or mercaptoalkyl groups bonded to silicon atoms per molecule
   (B-1) Crosslinkable polymethylhydrogensiloxane with an average unit formula represented by M^{H}₈Q₄ (SiH content: 10.16 mmol/g)
   (B-2) Crosslinkable polymethylhydrogensiloxane with an average unit formula represented by M^{H}D^{H}₉D₁₁M^{H} (SiH content: 8.27 mmol/g)
   (B-3) Crosslinkable polymethylhydrogensiloxane with an average unit formula represented by MD^{H}₂₃D₁₆M (SiH content: 8.60 mmol/g)
   (B-4) Polymethylsiloxane having at least two HS(CH₂)₃SiO_{3/2} units per molecule, with an average unit formula represented by M(T^{SH})₅D₆₀ (SH content: 0.94 mmol/g)

### Synthesis Example of (B-4)

To 1,549.2 g (12 mol) of dimethyldichlorosilane, 21.7 g (0.2 mol) of trimethylchlorosilane, 196.4 g (1.0 mol) of 3-mercaptopropyl trimethoxysilane, and 1,500 g of toluene in a 5 L separable flask equipped with a cooling reflux tube, a dropping funnel, and a three-one motor as a stirring device, was added dropwise a mixture of 1,000 g of water and 500 g of toluene from the dropping funnel over about 1 hour. Hydrolysis of the resulting mixture was performed with heating and stirring at 70°C for 2 hours. After completion of the reaction, the aqueous phase was separated and removed, the oil phase was washed with water again, and then dehydrated by heating at 100°C to 125°C. After dehydration, 1.5 g of 50 mass% potassium hydroxide aqueous solution was added, and a condensation reaction was carried out by heating and stirring at 115 to 125°C for 5 hours. The resulting condensated product was neutralized with ethylene chlorohydrine, and then 1,200 to 1,300 g of toluene was desolvated. The product was filtered using Super Celite Floss as a filter aid, and then the remaining toluene was removed under constant pressure and reduced pressure to obtain 928 g of polymethylsiloxane containing mercaptopropyl groups.

Average structural formula:

{(CH₃)₃SiO_{1/2}}{HS(CH₂)₃SiO_{3/2}}₅{(CH₃)₂SiO_{2/2}}₆₀

Component (C): Ultraviolet diffusing agent
(C-1) Untreated calcium carbonate (CUBE 18BH (manufactured by Maruo Calcium Co., Ltd.), average particle size: 2.0 µm (by laser diffraction/scattering method))
(C-2) Untreated alumina (AKP-G15 (manufactured by Sumitomo Chemical Co., Ltd.), average particle size: 0.01 µm (by optical microscope))
(C-3) Untreated alumina (AKP-G07 (manufactured by Sumitomo Chemical Co., Ltd.), average particle size: 0.02 µm (by optical microscope))
(C-4) Untreated alumina (AA-04 (manufactured by Sumitomo Chemical Co., Ltd.), average particle size: 0.4 µm (by optical microscope))
(C-5) Untreated alumina (AA-3 (manufactured by Sumitomo Chemical Co., Ltd.), average particle size: 3.0 µm (by laser diffraction/scattering method))
(C-6) Untreated ground silica (CRYSTALITE (registered trademark) 5X (manufactured by Tatsumori Ltd.), average particle size: 1.0 µm (by laser diffraction/scattering method))
(C-7) Untreated ground silica (CRYSTALITE (registered trademark) VX-S (manufactured by Tatsumori Ltd.), average particle size: 4.0 µm (by laser diffraction/scattering method))
(C-8) Calcium carbonate treated with fatty acid (Calfine (registered trademark) N-40 (manufactured by Maruo Calcium Co., Ltd.), average particle size: 0.04 µm (by optical microscope))
(C-9) Calcium carbonate treated with fatty acid (Calfine (registered trademark) YM10 (manufactured by Maruo Calcium Co., Ltd.), average particle size: 0.1 µm (by optical microscope))
(C-10) Calcium carbonate treated with fatty acid (Calfine (registered trademark) YM23 (manufactured by Maruo Calcium Co., Ltd.), average particle size: 0.23 µm (by optical microscope))
(C-11) Untreated calcium carbonate (KRS1 (manufactured by Maruo Calcium Co., Ltd.), average particle size: 0.4 µm (by optical microscope))
(C-12) Untreated calcium carbonate (CUBE-20KA (manufactured by Maruo Calcium Co., Ltd.), average particle size: 2.7 µm (by laser diffraction/scattering method))
(C-13) Untreated calcium carbonate (CUBE-50KA (manufactured by Maruo Calcium Co., Ltd.), average particle size: 5.8 µm (by laser diffraction/scattering method))
(C-14) Untreated calcium carbonate (CUBE-80KA (manufactured by Maruo Calcium Co., Ltd.), average particle size: 8.9 µm (by laser diffraction/scattering method))
(C-15) Untreated calcium carbonate (R-50A (manufactured by Maruo Calcium Co., Ltd.), average particle size: 14.5 µm (by laser diffraction/scattering method))
(C-16) Untreated calcium carbonate (R-70H (manufactured by Maruo Calcium Co., Ltd.), average particle size: 24.7 µm (by laser diffraction/scattering method))

Component (C'): Filler other than component (C)
(C'-1) Fumed silica surface-treated with silazane (ROX200S (manufactured by Evonik Industries AG), average particle size: 0.01 µm (by optical microscope))
(C'-2) Titanium dioxide (AEROXIDE (registered trademark) TiO2 P 25 (manufactured by Evonik Industries AG), average particle size: 0.03 µm (by optical microscope))
(C'-3) Titanium dioxide (TIPAQUE (registered trademark) A-100 (manufactured by Ishihara Sangyo Kaisha, Ltd.), average particle size: 0.15 µm (by optical microscope))
(C'-4) Methyl resin particles (TOSPEARL (registered trademark) 120 (manufactured by Momentive Performance Materials Japan LLC), average particle size: 2.0 µm (by laser diffraction/scattering method))

Component (D): Platinum catalyst activated by ultraviolet light or photoinitiator
(D-1) (Methylcyclopentadienyl)trimethyl platinum complex (manufactured by Strem Chemicals, Inc. (Germany), platinum content: 61.1 mass%) was diluted to 1.0 mass% with M^{Vi}Dₘ₁M^{Vi} (1) before use.
(D-2) 2-Hydroxy-2-methyl-1-phenylpropanone (Irgacure (registered trademark) 1173, manufactured by IGM Resins B.V.) was used.

### Example 1

### (1) Preparation of mixture of components (A) and (C)

25 parts by mass of (C-1) was added to 25 parts by mass of (A-1) M^{Vi}Dₘ₁M^{Vi} (1), and the mixture was stirred for 2 minutes with a rotating/revolving mixer (ARE-501, manufactured by Thinky Corporation). Then, 50 parts by mass of (A-1) was added in 10 parts by mass at a time to avoid clumping, and the mixture was stirred for 2 minutes at each addition using the rotating/revolving mixer to prepare a base solution.

To the base solution thus obtained was added (A-1) little by little to avoid clumping, and the mixture was stirred for 2 minutes at each addition using the rotating/revolving mixer to obtain a mixture of 100.00 parts by mass of (A-1) and 0.10 parts by mass of (C-1).

### Preparation of UV-curable silicone composition

To the mixture thus obtained, 0.17 parts by mass of 1.0 mass% diluted solution of (D-1) ((D-1): 0.0017 parts by mass, M^{Vi}Dₘ₁M^{Vi} (1): 0.1683 parts by mass) and 1.78 parts by mass of (B-1) were added and mixed in a yellow room to obtain the UV-curable silicone composition of Example 1.

### Examples 2 to 30

The mixtures of the components (A) and (C) were prepared in the same manner as in Example 1, except that the components (A) to (D) and their contents were changed as shown in Tables 1 and 2, to obtain the UV-curable silicone compositions of Examples 2 to 30.

### Example 31

In the same manner as in Example 1, a mixture of 100.00 parts by mass of (A-4) and 0.25 parts by mass of (C-1) was obtained. To the mixture thus obtained, 0.30 parts by mass of (D-2) and 15.40 parts by mass of (B-4) were added and mixed in a yellow room to obtain the UV-curable silicone composition of Example 31.

### Comparative Examples 1 to 6

The mixtures of the components (A) and (C) or (C') were prepared in the same manner as in Example 1, except that the components (A) to (D) and their contents were changed as shown in Table 3, to obtain the UV-curable silicone compositions of Comparative Examples 1 to 6.

### Comparative Example 7

In the same manner as in Example 1, a mixture of 100.00 parts by mass of (A'-1) and 0.25 parts by mass of (C-1) was obtained. To the mixture thus obtained, 1.00 part by mass of (D-2) was added and mixed in a yellow room to obtain the UV-curable silicone composition of Comparative Example 7.

The formulations and evaluation results of the Examples are shown in Tables 1 and 2. The formulations and evaluation results of the Comparative Examples are shown in Table 3.

### [Table 1]

**Table 1**

| | | | mmol/g | Example 1 | Example 2 | Example 3 | Example 4 | Example 5 | Example 6 | Example 7 | Example 8 | Example 9 | Example 10 | Example 11 | Example 12 | Example 13 | Example 14 | Example 15 |
|---|---|---|---|---|---|---|---|---|---|---|---|---|---|---|---|---|---|---|
| (A) | (A-1) M^{Vi}Dₘ₁ M^{Vi}(1) (Vi content:0.180 mmol/g) | | 0.180 | 100.00 | 100.00 | 100.00 | 100.00 | 100.00 | 100.00 | 100.00 | 100.00 | 100.00 | 100.00 | | | | 100.00 | 100.00 |
| | (A-2) M^{Vi}Dᵣₙ₂M^{Vi}(2) (Vi content:0.047 mmol/g) | | 0.047 | | | | | | | | | | | 100.00 | 25.00 | | | |
| | (A-3) M^{Vi}Dₘ₃M^{Vi}(3) (Vi content:0.029 mmol/g) | | 0.029 | | | | | | | | | | | | 75.00 | 100.00 | | |
| (B) | (B-1) M^{H}₈Q₄ crosslinking agent (SiH content: 10.16 mmol/g) | | 10.16 | 1.78 | 1.78 | 1.78 | 1.78 | 1.78 | 1.78 | | | 1.78 | 1.78 | 0.47 | 0.33 | 0.29 | 0.88 | 3.51 |
| | (B-2) M^{H}D^{H}₉D₁₁M^{H} crosslinking agent (SiH content:8.27 | mmol/g) | 8.27 | | | | | | | 2.17 | | | | | | | | |
| | (B-3) MD^{H}₂₃D₁₆M crosslinking agent (SiH content:8.60 | mmol/g) | 8.60 | | | | | | | | 2.09 | | | | | | | |
| (C) | (C-1) Untreated calcium carbonate (CUBE18BH, average particle size : 2.0 µm) | | | 0.10 | 0.25 | 0.50 | 1.00 | 2.00 | 10.00 | 0.25 | 0.25 | 0.25 | 0.25 | 0.25 | 0.25 | 0.25 | 0.25 | 0.25 |
| (D) | (D-1) (Methylcyclopentadienyl) trimethyl platinum complex (1.0% M^{Vi}Dₘ₁M^{Vi}(1) diluted solution) | | | 0.17 | 0.17 | 0.17 | 0.17 | 0.17 | 0.17 | 0.17 | 0.17 | 0.08 | 0.51 | 0.17 | 0.17 | 0.17 | 0.17 | 0.17 |
| Total | | | | 102.05 | 102.20 | 102.45 | 102.95 | 103.95 | 111.95 | 102.59 | 102.51 | 102.11 | 102.54 | 100.89 | 100.75 | 100.71 | 101.30 | 103.93 |
| SiH/Vi ratio or SH/Vi ratio | | | | 1.00 | 1.00 | 1.00 | 1.00 | 1.00 | 1.00 | 1.00 | 1.00 | 1.00 | 1.00 | 1.02 | 1.00 | 1.02 | 0.50 | 1.98 |
| SiH content or SH content (mmol) | | | | 18.1 | 18.1 | 18.1 | 18.1 | 18.1 | 18.1 | 17.9 | 18.0 | 18.1 | 18.1 | 4.8 | 3.4 | 2.9 | 8.9 | 35.7 |
| Vi group content (mmol) | | | | 18.0 | 18.0 | 18.0 | 18.0 | 18.0 | 18.0 | 18.0 | 18.0 | 18.0 | 18.0 | 4.7 | 3.4 | 2.9 | 18.0 | 18.0 |
| **Pt** content (ppm) | | | | 10.2 | 10.2 | 10.2 | 10.2 | 10.2 | 10.2 | 10.1 | 10.2 | 4.8 | 30.5 | 10.3 | 10.3 | 10.3 | 10.3 | 10.0 |
| Absorbance of mixture of 100 pts by mass of (A) + 0.25 pts by mass of (C) / JIS K0115, 365 nm, 200 um thick measurement | | | | 0.064 | 0.064 | 0.064 | 0.064 | 0.064 | 0.064 | 0.064 | 0.064 | 0.064 | 0.064 | 0.088 | 0.111 | 0.138 | 0.064 | 0.064 |
| Viscosity (immediately after preparation) | | | mPas | 440 | 440 | 440 | 440 | 460 | 540 | 440 | 440 | 440 | 440 | 11,980 | 55.000 | 80.100 | 480 | 440 |
| Viscosity (23°C, after 24h) | | | mPas | 440 | 440 | 440 | 440 | 460 | 540 | 440 | 440 | 440 | 440 | 12,200 | 55.000 | 80.600 | 480 | 440 |
| Percent transmittance / JIS K0115, before curing, 365 nm, 10 mm thick measurement→converted to 1 mm thick | | | % | 82 | 67 | 50 | 48 | 45 | 34 | 66 | 62 | 61 | 59 | 64 | 63 | 63 | 66 | 61 |
| Absorbance / JIS K0115, before curing, 365 nm, 200 um thick measurement | | | - | 0.022 | 0.050 | 0.124 | 0.288 | 0.683 | 2.541 | 0.050 | 0.057 | 0.054 | 0.061 | 0.100 | 0.122 | 0.156 | 0.063 | 0.069 |
| Shore 00 hardness ASTM D 2240 | | | - | 73 | 75 | 74 | 74 | 75 | 75 | 75 | 76 | 71 | 75 | 61 | 50 | 50 | 0 | 77 |
| Gelling time (UV irradiation (4,500 mJ/cm²) ,23°C) | | | min | 1.6 | 1.6 | 1.6 | 1.6 | 1.5 | 1.5 | 0.5 | 0.6 | 2.2 | 1.2 | 0.9 | 0.8 | 0.8 | 49 | 1.4 |
| Curing diameter of shielded area | | Top diameter Φ | mm | 15.4 | 22.0 | 19.7 | 19.5 | 16.0 | 14.6 | 15.6 | 15.8 | 13.3 | 25.8 | 23.7 | 13.4 | 11.5 | 14.0 | 17.6 |
| | | Middle diameter | mm Φ | 21.3 | 26.6 | 24.1 | 22.6 | 20.4 | 17.5 | 20.7 | 21.4 | 20.3 | 32.5 | 26.2 | 18.5 | 16.5 | 16.9 | 22.3 |
| | | Bottom diameter Φ | mm | 34.6 | 40.3 | 31.8 | 28.7 | 24.6 | 20.8 | 36.7 | 34.9 | 32.5 | 46.8 | 23.8 | 20.2 | 18.4 | 35.9 | 33.4 |

### [Table 2]

**Table 2**

| | | | mmol/g | Example 16 | Example 17 | Example 18 | Example 19 | Example 20 | Example 21 | Example 22 | Example 23 | Example 24 | Example 25 | Example 26 | Example 27 | Example 28 | Example 29 | Example 30 | Example31 |
|---|---|---|---|---|---|---|---|---|---|---|---|---|---|---|---|---|---|---|---|
| (A) | (A-1) M^{Vi}Dₘ₁M^{Vi}(1) (Vi content:0.180 mmol/g) | | 0.18 | 100.00 | 100.00 | 100.00 | 100.00 | 100.00 | 100.00 | 100.00 | 100.00 | 100.00 | 100.00 | 100.00 | 100.00 | 100.00 | 100.00 | 100.00 | |
| | (A-4) M^{Vi}Dₘ₄M^{Vi}(4) (Vi content:0.145 mmol/g) | | 0.145 | | | | | | | | | | | | | | | | 100.00 |
| (B) | (B-1) M^{H}₈Q₄ crosslinking agent (SiH content:10.16 mmol/g) | | 10.16 | 1.78 | 1.78 | 1.78 | 1.78 | 1.78 | 1.78 | 1.78 | 1.78 | 1.78 | 1.78 | 1.78 | 1.78 | 1.78 | 1.78 | 1.78 | |
| | (B-4) M(T^{SH})₅D₆₀ crosslinking agent (SH content:0.94 mmol/g) | | 0.94 | | | | | | | | | | | | | | | | 15.40 |
| (C) | (C-1) Untreated calcium carbonate (CUBE18BH, average particle size : 2.0 µm) | | | | | | | | | | | | | | | | | | 0.25 |
| | (C-2) Untreated alumina (AKP-G15, average particle size : 0.01 µm) | | | 0.25 | | | | | | | | | | | | | | | |
| | (C-3) Untreated alumina (AKP-G07, average particle size : 0.02 µm) | | | | 0.25 | | | | | | | | | | | | | | |
| | (C-4) Untreated alumina (AA-04, average particle size : 0.4 µm) | | | | | 0.25 | | | | | | | | | | | | | |
| | (C-5) Untreated alumina (AA-3, average particle size : 3.0 µm) | | | | | | 0.25 | | | | | | | | | | | | |
| | (C-6) Untreated ground silica (CRYSTALITE^{®} 5X, average particle size : 1.0 µm) | | | | | | | 0.25 | | | | | | | | | | | |
| | (C-7) Untreated ground silica (CRYSTALITE^{®} VX-S, average particle size : 4.0 µm) | | | | | | | | 0.25 | | | | | | | | | | |
| | (C-8) Calcium carbonate treated with fatty acid (Calfine^{®} N-40, average particle size : 0.04 µm) | | | | | | | | | 0.25 | | | | | | | | | |
| | (C-9) Calcium carbonate treated with fatty acid (Calfine^{®} YM10, average particle size : 0.1 µm) | | | | | | | | | | 0.25 | | | | | | | | |
| | (C-10) Calcium carbonate treated with fatty acid (Calfine^{®} YM23, average particle size : 0.23 µm) | | | | | | | | | | | 0.25 | | | | | | | |
| | (C-11) Untreated calcium carbonate (KRS1, average particle size : 0.4 µm) | | | | | | | | | | | | 0.25 | | | | | | |
| | (C-12) Untreated calcium carbonate (CUBE-20KA, average particle size : 2.7 µm) | | | | | | | | | | | | | 0.25 | | | | | |
| | (C-13) Untreated calcium carbonate (CUBE-50KA, average particle size : 5.8 µm) | | | | | | | | | | | | | | 0.25 | | | | |
| | (C-14) Untreated calcium carbonate (CUBE-80KA, average particle size : 8.9 µm) | | | | | | | | | | | | | | | 0.25 | | | |
| | (C-15) Untreated calcium carbonate (R-50A, average particle size : 14.5 µm) | | | | | | | | | | | | | | | | 0.25 | | |
| | (C-16) Untreated calcium carbonate (R-70H, average particle size : 24.7 µm) | | | | | | | | | | | | | | | | | 0.25 | |
| (D) | (D-1) (Methylcyclopentadienyl) trimethyl platinum complex (1.0% M^{Vi}Dₘ₁M^{Vi}(1) diluted solution) | | | 0.17 | 0.17 | 0.17 | 0.17 | 0.17 | 0.17 | 0.17 | 0.17 | 0.17 | 0.17 | 0.17 | 0.17 | 0.17 | 0.17 | 0.17 | |
| | (D-2) Photoinitiator (Irgacure 1173) | | | | | | | | | | | | | | | | | | 0.30 |
| Total | | | | 102.20 | 102.20 | 102.20 | 102.20 | 102.20 | 102.20 | 102.20 | 102.20 | 102.20 | 102.20 | 102.20 | 102.20 | **102.20** | 102.20 | 102.20 | 115.95 |
| SiH/Vi ratio or SH/Vi ratio | | | | 1.00 | 1.00 | 1.00 | 1.00 | 1.00 | 1.00 | 1.00 | 1.00 | 1.00 | 1.00 | 1.00 | 1.00 | 1.00 | 1.00 | 1.00 | 1.00 |
| SiH content or SH content (mmol) | | | | 18.1 | 18.1 | 18.1 | 18.1 | 18.1 | 18.1 | 18.1 | 18.1 | 18.1 | 18.1 | 18.1 | 18.1 | 18.1 | 18.1 | 18.1 | 14.5 |
| Vi group content (mmol) | | | | 18.0 | 18.0 | 18.0 | 18.0 | 18.0 | 18.0 | 18.0 | 18.0 | 18.0 | 18.0 | 18.0 | 18.0 | 18.0 | 18.0 | 18.0 | 14.5 |
| Pt content (ppm) | | | | 10.2 | *10.2* | 10.2 | 10.2 | 10.2 | 10.2 | 10.2 | 10.2 | 10.2 | 10.2 | 10.2 | 10.2 | 10.2 | 10.2 | 10.2 | - |
| Absorbance of mixture of 100 pts by mass of (A) + 0.25 pts by mass of (C) / JIS K0115, 365 nm, 200 um thick measurement | | | | 0.117 | 0.160 | 0.180 | 0.059 | 0.195 | 0.091 | 0.129 | 0.296 | 0.202 | 0.232 | 0.057 | 0.045 | 0.042 | 0.052 | 0.034 | 0.091 |
| Viscosity (immediately after preparation) | | | mPas | 460 | 440 | 440 | 440 | 440 | 440 | 480 | 460 | 440 | 440 | 440 | 440 | 440 | 440 | 440 | 940 |
| Viscosity (23°C, after 24h) | | | mPas | 480 | 480 | 440 | 440 | 440 | 440 | 500 | 460 | 440 | 440 | 440 | 440 | 440 | 440 | 440 | 940 |
| Percent transmittance / JIS K0115, before curing, 365 nm, 10 mm thick measurement→converted to 1 mm thick | | | % | 58 | 53 | 48 | 72 | 54 | 66 | 66 | 48 | 49 | 49 | 72 | 82 | 88 | 77 | 83 | 67 |
| Absorbance / JIS K0115, before curing, 365 nm, 200 um thick measurement | | | - | 0.130 | 0.171 | 0.227 | 0.053 | 0.238 | 0.107 | 0.130 | 0.266 | 0.264 | 0.281 | 0.099 | 0.041 | 0.038 | 0.031 | 0.021 | 0.072 |
| Shore 00 hardness ASTM D 2240 | | | - | 73 | 73 | 74 | 74 | 75 | 75 | 73 | 75 | 75 | 74 | 74 | 74 | 74 | 75 | 75 | 72 |
| Gelling time (UV irradiation (4,500mJ/cm²), 23°C | | | min | 1.7 | 1.6 | 1.9 | 1.9 | 1.7 | 1.7 | 1.7 | 1.7 | 1.7 | 1.6 | 1.6 | 1.6 | 1.7 | 1.7 | 1.8 | 0.1 |
| Curing diameter of shielded area | | Top diameter Φ | mm | 14.5 | 16.8 | 13.2 | 12.8 | 18.1 | 7.0 | 12.9 | 19.6 | 19.6 | 15.2 | 18.9 | 15.2 | 13.5 | 11.3 | 7.2 | 19.1 |
| | | Middle diameter Φ | mm | 19.6 | 223 | 18.8 | 15.6 | 25.7 | 18.5 | 15.1 | 24.1 | 24.7 | 23.6 | 25.3 | 21.6 | 19.1 | 19.9 | 16.2 | 23.1 |
| | | Bottom diameter Φ | mm | 37.0 | 36.0 | 24.2 | 26.2 | 39.8 | 36.2 | 41.7 | 38.2 | 39.0 | 33.3 | 37.7 | 24.7 | 32.0 | 35.8 | 31.5 | 23.9 |

**[Table 3]**

| | | | mmol/g | Comparative Example 1 | Comparative Example 2 | Comparative Example 3 | Comparative Example **4** | Comparative Example 5 | Comparative Example 6 | Comparative Example 7 |
|---|---|---|---|---|---|---|---|---|---|---|
| (A) | (A-1) M^{Vi}Dₘ₁M^{Vi}(1) (Vi content:0.180 mmol/g) | | 0.180 | 100.00 | 100.00 | 100.00 | 100.00 | 100.00 | 100.00 | |
| (A') | (A'-1) 1,3-Bis(3-methacryloxypropyl)tetramethyldisiloxane | | - | | | | | | | 100.00 |
| (B) | (B-1) M^{H}₈Q₄ crosslinking agent (SiH content:10.16 mmol/g) | | 10.16 | 1.78 | 1.78 | 1.78 | 1.78 | 1.78 | 1.78 | |
| (C) | (C-1) Untreated calcium carbonate (CUBE18BH, average particle size : 2.0 µm) | | | | 20.00 | | | | | 0.25 |
| (C') | (C'-1) Surface-treated fumed silica (ROX200S, average particle size : 0.01 µm) | | | | | 0.25 | | | | |
| | (C'-2) Titanium dioxide (AEROXIDE^{®} TiO2P 25, average particle size : 0.03 µm) | | | | | | 0.25 | | | |
| | (C'-3) Titanium dioxide (TIPAQUEO) A-100, average particle size : 0.15 µm) | | | | | | | 0.25 | | |
| | (C'-4) Resin particles (TOSPEARL^{®} 120, average particle size : 2.0 µm) | | | | | | | | 0.25 | |
| (D) | (D-1) (Methylcyclopentadienyl) trimethyl platinum complex (1.0% M^{Vi}Dₘ₁M^{Vi}(1) diluted solution) | | | 0.17 | 0.17 | 0.17 | 0.17 | 0.17 | 0.17 | |
| | (D-2) Photoinitiator (Irgacure 1173) | | | | | | | | | 1.00 |
| Total | | | | 101.95 | 121.95 | 102.20 | 102.20 | 102.20 | 102.20 | 101.25 |
| SiH/Vi ratio or SH/Vi ratio | | | | 1.00 | 1.00 | 1.00 | 1.00 | 1.00 | 1.00 | |
| SiH content or SH content (mmol) | | | | 18.1 | 18.1 | 18.1 | 18.1 | 18.1 | 18.1 | |
| Vi group content (mmol) | | | | 18.0 | 18.0 | 18.0 | 18.0 | 18.0 | 18.0 | |
| Pt content (ppm) | | | | 10.2 | 10.2 | 10.2 | 10.2 | 10.2 | 10.2 | |
| Absorbance of mixture of 100 pts by mass of (A) + 0.25 pts by mass of (C) / JIS K0115, 365 nm, 200 um thick measurement | | | | | 0.064 | 0.012 | 0.704 | 0.526 | 0.006 | 0.147 |
| Viscosity (immediately after preparation) | | | mPas | 440 | 640 | 460 | 460 | 450 | 440 | 80 |
| Viscosity (23°C, after 24h) | | | mPas | 460 | 640 | 460 | 480 | 460 | 440 | 80 |
| Percent transmittance / JIS K0115, before curing, 365 nm, 10 mm thick measurement-converted to 1 mm thick | | | % | 100 | 32 | 99 | 32 | 32 | 98 | 38 |
| Absorbance / JIS K0115, before curing, 365 nm, 200 um thick measurement | | | - | 0.008 | 2.755 | 0.012 | 1.209 | 1.020 | 0.008 | 0.110 |
| Shore 00 hardness ASTM D 2240 | | | - | 72 | Bottom uncured | 74 | Uncured | Uncured | 74 | 100 |
| Gelling time (UV irradiation (4,500mJ/cm²) , 23°C) | | | min | 1.7 | 1.7 | 1.6 | Uncured | Uncured | 1.6 | 0.2 |
| Curing diameter of shielded area | | Top diameter Φ | mm | 8.2 | 10.9 | 7.9 | Uncured | Uncured | 7.4 | 11.9 |
| | | Middle diameter Φ | mm | 13.1 | 13.2 | 12.7 | Uncured | Uncured | 11.1 | 10.0 |
| | | Bottom diameter Φ | mm | 17.2 | 17.3 | 17.7 | Uncured | Uncured | 15.8 | 7.1 |

As shown in Tables 1 and 2, the compositions of the Examples that are UV-curable silicone compositions containing (A) a polyorganosiloxane having at least two alkenyl groups per molecule; (B) a polyorganosiloxane having at least two hydrogen atoms or mercaptoalkyl groups bonded to silicon atoms per molecule; (C) an ultraviolet diffusing material; and (D) a platinum catalyst activated by ultraviolet light or a photoinitiator, wherein the content of the component (C) based on 100 parts by mass of the component (A) is 0.05 to 15.0 parts by mass, and the percent transmittance of the compositions before curing, measured at a wavelength of 365 nm in accordance with JIS K 0115, is 33 to 95%, had a short gelling time, excellent curability, as well as excellent curability in areas not exposed to light and in the thickness direction.

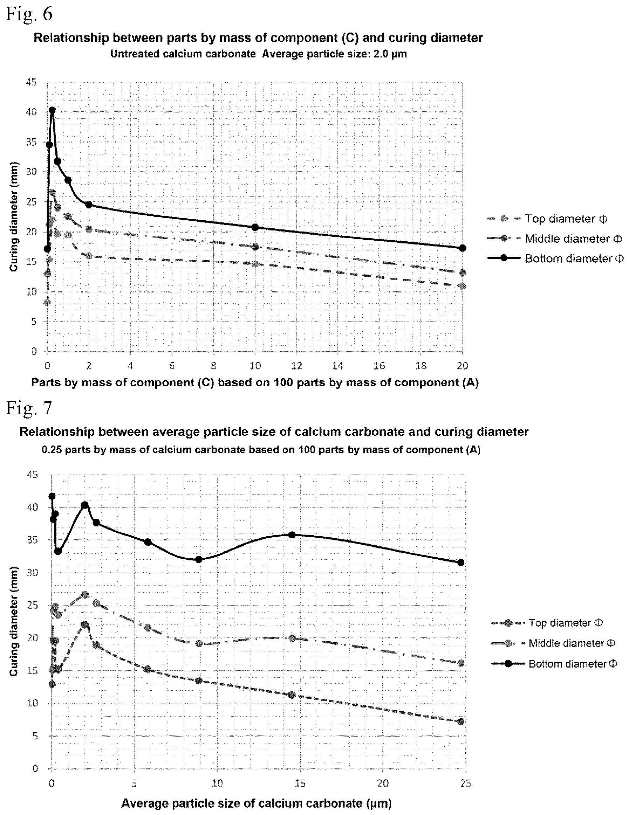

Fig. 6 is a graph showing the relationship between the parts by mass of (C-1) untreated calcium carbonate (average particle size: 2.0 µm) based on 100 parts by mass of (A-1), and the curing diameters at the top (depth: 0 mm), middle (depth: 2.9 mm) and bottom (depth: 5.8 mm), based on Examples 1 to 6 and Comparative Examples 1 and 2. Fig. 6 shows that the curing diameter of Example 1, which contains only 0.10 parts by mass of (C-1), is 1.6 to 2.0 times larger than that of Comparative Example 1, which contains no component (C), indicating that the curing diameter of the composition is greatly increased just by adding a small amount of the component (C). This also shows that the curing diameter reaches a maximum when the content of (C-1) is around 0.25 parts by mass, and then gradually decreases as the content of (C-1) increases.

Fig. 7 is a graph showing the relationship between the average particle size of calcium carbonate and the curing diameters at the top (depth: 0 mm), middle (depth: 2.9 mm) and bottom (depth: 5.8 mm), in a composition formulated with 0.25 parts by mass of calcium carbonate as the component (C) based on 100 parts by mass of (A-1), based on Examples 2 and 22 to 30. Fig. 7 shows that when the average particle size of calcium carbonate is 2.0 µm or less, the effect of increasing the curing diameter is large, and when it exceeds 15 µm, the curing diameter tends to decrease.

Comparison of Examples 2, 7, and 8 shows that Example 2, in which the component (B) is a polyorganohydrogensiloxane containing M^{H} units and Q units, has an even better curing diameter than those in which the component (B) is linear. Comparison of Examples 2 and 11 to 13 shows that Example 2, in which the alkenyl group content of the component (A) is on average 0.10 mmol/g or more, has an even better curing diameter.

Comparative Example 1, which did not contain the component (C), and Comparative Example 2, in which the content of the component (C) based on 100 parts by mass of the component (A) exceeded 15 parts by mass, had inferior curing diameters. Comparative Examples 3 and 6, which contained surface-treated fumed silica and resin particles, respectively, instead of the component (C), had a percent transmittance of the composition before curing, measured at a wavelength of 365 nm, exceeding 95%, but resulted in an inferior curing diameter. Comparative Examples 4 and 5, which contained titanium dioxide instead of the component (C) and had a percent transmittance of the composition before curing measured at a wavelength of 365 nm of less than 33%, had significantly inferior curability by ultraviolet light and the curing diameter could not be evaluated. Comparative Example 7, which used a curing system of siloxane oligomers with methacrylic functional groups at both ends instead of the components (A) and (B), and contained the component (C), had a short gelling time and a fast curing speed, but a significantly inferior curing diameter.

### INDUSTRIAL APPLICABILITY

The cured product of the UV-curable silicone composition is useful as an encapsulating material for electrical components, electronic components, and the like.

### REFERENCE SIGNS LIST

1 Depression
2 Hole
3 Transparent glass
4 Black tape for the bottom
5 Black tape for the top
6 Metal mold
7 Sample (UV-curable silicone composition)
8 Cured area
9 Curing diameter

## Claims

1. An UV-curable silicone composition, comprising:
(A) a polyorganosiloxane having at least two alkenyl groups per molecule,
(B) a polyorganosiloxane having at least two hydrogen atoms or mercaptoalkyl groups bonded to silicon atoms per molecule,
(C) an ultraviolet diffusing material, and
(D) a platinum catalyst activated by ultraviolet light or a photoinitiator,
wherein a content of the component (C) based on 100 parts by mass of the component (A) is 0.05 to 15.0 parts by mass, and
a percent transmittance of the composition before curing, measured at a wavelength of 365 nm in accordance with JIS K 0115, is 33 to 95%.

2. The UV-curable silicone composition according to claim 1, wherein an absorbance at a wavelength of 365 nm, of a mixture of 100 parts by mass of the component (A) and 0.25 parts by mass of the component (C), measured in accordance with JIS K 0115, using, instead of a glass cell, a sample produced by using a spacer and two glass plates to make the thickness of the mixture 200 µm, is in the range of 0.005 to 0.5.

3. The UV-curable silicone composition according to claim 1 or 2, wherein a cured product, which is obtained by irradiating the composition with ultraviolet light having a diameter of 7.0 mm, an illuminance of 100 mW/cm², and a wavelength of 365 nm for 45 seconds in a yellow room, and then storing it at 23°C for 16 hours, has a curing diameter at a depth of 5.8 mm, of 18 mm or more.

4. The UV-curable silicone composition according to claim 1 or 2, wherein an average particle size of the component (C) is 0.01 to 25 µm.

5. The UV-curable silicone composition according to claim 1 or 2, wherein the component (C) is selected from the group consisting of calcium carbonate, silica, and alumina.

6. The UV-curable silicone composition according to claim 1 or 2, wherein the component (A) comprises a linear polyorganosiloxane, and an alkenyl group content of the component (A) is on average 0.03 to 1.0 mmol/g.

7. The UV-curable silicone composition according to claim 1 or 2, wherein the component (B) is (B-1) a polyorganohydrogensiloxane having at least two hydrogen atoms bonded to silicon atoms per molecule, and the component (D) is (D-1) a platinum catalyst activated by ultraviolet light.

8. The UV-curable silicone composition according to claim 7, wherein the component (B-1) comprises (b1) a polyorganohydrogensiloxane comprising a R^{c1}₂HSiO_{1/2} unit (wherein R^{c1} is independently a C₁-C₆ alkyl group or a C₆-C₂₀ aryl group) and a SiO_{4/2} unit.

9. The UV-curable silicone composition according to claim 7, wherein the component (D-1) is a platinum catalyst having a cyclic diene compound as a ligand, and a content of the component (D-1) in the composition is 1 to 50 ppm as platinum metal mass.

10. The UV-curable silicone composition according to claim 7, wherein a ratio of the number of moles H_{B} of hydrogen atoms bonded to silicon atoms in the component (B-1) to the number of moles Vi_{A} of alkenyl groups in the component (A), H_{B}/Vi_{A} ratio, is 0.3 to 2.0.

11. The UV-curable silicone composition according to claim 1 or 2, wherein the component (B) is (B-2) a polyorganosiloxane having at least two mercaptoalkyl groups bonded to silicon atoms per molecule, and the component (D) is (D-2) a photoinitiator.

12. The UV-curable silicone composition according to claim 11, wherein the component (B-2) comprises (b2) a polyorganosiloxane comprising at least two R^{d1}SiO_{3/2} units (wherein R^{d1} is a mercaptoalkyl group having 1 to 6 carbon atoms) per molecule.

13. A potting material, comprising the UV-curable silicone composition according to claim 1 or 2.

14. The potting material according to claim 13, which is for a connector pin.

15. An encapsulating material, comprising a cured product of the UV-curable silicone composition according to claim 1 or 2.

16. The encapsulating material according to claim 15, which is for an electrical component or an electronic component.

17. The encapsulating material according to claim 16, wherein the electrical component or electronic component is a connector having a connector pin.
